# EUROPEAN PATENT APPLICATION

(11) **EP 4 597 559 A1**
(43) Date of publication of application: **06.08.2025**
(21) Application number: 23871316.8
(22) Date of filing: 13.06.2023
(51) Int. Cl.: H01L 21/683, H05B 3/20

(54) **STAGE**

(30) Priority: 30.09.2022 JP 2022158331
(71) Applicant: NHK Spring Co., Ltd., Yokohama-shi, Kanagawa 236-0004 (JP)
(72) Inventor: FUTAKUCHIYA, Jun, Yokohama-shi, Kanagawa 236-0004 (JP); AIKAWA, Naoya, Yokohama-shi, Kanagawa 236-0004 (JP)
(74) Representative: dompatent von Kreisler Selting Werner - Partnerschaft von Patent- und Rechtsanwälten mbB
(86) International application number: PCT/JP2023/021870
(87) International publication number: WO 2024/070071

(57) **Abstract**

A stage includes a first metal plate including a first groove, a second metal plate including a through hole below the first metal plate, a third metal plate including a second groove below the second metal plate, a heat insulating portion in which the first groove, the through hole, and the second groove are connected to one another, a first circulating flow path and a first heater provided in one of the first metal plate, the second metal plate, and the third metal plate, and one of a second circulating flow path and a second heater. The first circulating flow path and the second circulating flow path are provided in a first region defined by the heat insulating portion as a boundary. The first heater and the second heater are provided in a second region opposite the first region defined by the heat insulating portion as the boundary.

## Description

### TECHNICAL FIELD

An embodiment of the present invention relates to a stage on which a wafer or the like is placed.

### BACKGROUND ART

A semiconductor apparatus for manufacturing a semiconductor element is provided with a stage on which a wafer is placed. Ceramics are generally used for the stage from the viewpoints of the degree of freedom in heater arrangement, contamination, heat resistance, and the like. For example, for a stage using ceramics, Patent Literature 1 discloses a ceramic plate having a temperature gradient profile in which the temperature of the inner peripheral region and the temperature of the outer peripheral region are different by controlling a heater element in the inner peripheral region and a heater element in the outer peripheral region, respectively. In the ceramic plate disclosed in the Patent Literature 1, the temperature increases from the inner peripheral region toward the outer peripheral region, and it is possible to achieve a temperature gradient profile in which the temperature difference between the inner peripheral region and the outer peripheral region is about 10°C.

### CITATION LIST

### PATENT LITERATURE

Patent Literature 1: International patent publication No. WO2018/030433

### SUMMARY OF INVENTION

### TECHNICAL PROBLEM

In recent years, there has been demand for a larger temperature difference between the inner and outer regions of a stage. However, when the temperature difference between the inner region and the outer region exceeds 10°C in a stage using ceramics, the stage may be damaged.

In view of the above problem, one object of an embodiment of the present invention is to provide a stage capable of achieving a temperature gradient profile with a large temperature difference between an inner region and an outer region.

### SOLUTION TO PROBLEM

A stage according to an embodiment of the present invention includes a first metal plate including a first groove, a second metal plate including a through hole below the first metal plate, a third metal plate including a second groove below the second metal plate, a heat insulating portion in which the first groove, the through hole, and the second groove are connected to one another, a first circulating flow path and a first heater provided in one of the first metal plate, the second metal plate, and the third metal plate, and at least one of a second circulating flow path and a second heater. The first circulating flow path and the second circulating flow path are provided in a first region defined by the heat insulating portion as a boundary. The first heater and the second heater are provided in a second region opposite the first region defined by the heat insulating portion as the boundary.

The first region may be a region surrounded by the heat insulating portion.

The second heater may be provided in the metal plate in which the first heater is provided. One of two adjacent metal plates may be the metal plate in which the first heater is provided, and the second circulating flow path may be provided in the other of the two adjacent metal plates. One of two spaced apart metal plates may be the metal plate in which the first heater is provided, and the second circulating flow path may be provided in the other of the two spaced apart metal plates.

One of two adjacent metal plates may be the metal plate in which the first heater is provided, and the second heater may be provided in the other of the two adjacent metal plates. The second circulating flow path may be provided in the other of the two adjacent metal plates. The second circulating flow path may be provided in a metal plate different from the two adjacent metal plates.

One of two spaced apart metal plates may be the metal plate in which the first heater is provided, and the second heater may be provided in the other of the two spaced apart metal plates. The second circulating flow path may be provided in the other of the two adjacent metal plates. The second circulating flow path may be provided in a metal plate different from the two adjacent metal plates.

A cross-sectional diameter of the second heater may be different from a cross-sectional diameter of the first heater.

The first heater and the second heater may be electrically isolated from each other.

Further, a stage according to an embodiment of the present invention includes a first metal plate including a first groove, a second metal plate including a through hole below the first metal plate, a third metal plate including a second groove below the second metal plate, a heat insulating portion in which the first groove, the through hole, and the second groove are connected to one another, a first circulating flow path provided in one of the first metal plate, the second metal plate, and the third metal plate, a first heater provided in the other metal plate different from the one metal plate, and at least one of a second circulating flow path and a second heater provided in a metal plate different from the one metal plate and the other metal plate. The first circulating flow path and the second circulating flow path are provided in a first region defined by the heat insulating portion as a boundary, and the first heater and the second heater are provided in a second region opposite the first region defined by the heat insulating portion as the boundary.

The one metal plate and the other metal plate may be adjacent to each other.

The one metal plate and the other metal plate may be spaced apart from each other.

A temperature difference between a minimum surface temperature and a maximum surface temperature of the first metal plate may be higher than or equal to 20°C.

### ADVANTAGEOUS EFFECTS OF INVENTION

A stage according to an embodiment of the present invention can achieve a temperature gradient profile with a large temperature difference between an inner region and an outer region. Therefore, even when a temperature drop in the inner region or the outer region of a wafer placed on the stage is significant, the temperature of the inner region or the outer region of the wafer can be corrected to uniformize the temperature distribution in the wafer.

### BRIEF DESCRIPTION OF DRAWINGS

FIG. 1 is a schematic perspective view showing a configuration of a stage according to an embodiment of the present invention.
FIG. 2 is a schematic top view showing a configuration of a stage according to an embodiment of the present invention.
FIG. 3 is a schematic cross-sectional view showing a configuration of a stage according to an embodiment of the present invention.
FIG. 4A is a schematic plan view showing a configuration of a circulating flow path of a stage according to an embodiment of the present invention.
FIG. 4B is a schematic plan view showing a configuration of a circulating flow path of a stage according to an embodiment of the present invention.
FIG. 5 is a schematic cross-sectional view showing a configuration of a plate portion of a stage according to an embodiment of the present invention.
FIG. 6 is a schematic plan view showing a configuration of a second metal plate of a stage according to an embodiment of the present invention.
FIG. 7 is a schematic plan view showing a configuration of a second metal plate of a stage according to an embodiment of the present invention.
FIG. 8 is a graph illustrating a temperature gradient profile of a stage according to an embodiment of the present invention.
FIG. 9 is a schematic cross-sectional view showing a configuration of a plate portion of a stage according to an embodiment of the present invention.
FIG. 10 is a schematic cross-sectional view showing a configuration of a plate portion of a stage according to an embodiment of the present invention.
FIG. 11 is a schematic cross-sectional view showing a configuration of a plate portion of a stage according to an embodiment of the present invention.
FIG. 12 is a schematic cross-sectional view showing a configuration of a plate portion of a stage according to an embodiment of the present invention.
FIG. 13 is a schematic cross-sectional view showing a configuration of a plate portion of a stage according to an embodiment of the present invention.
FIG. 14 is a schematic cross-sectional view showing a configuration of a plate portion of a stage according to an embodiment of the present invention.
FIG. 15 is a schematic cross-sectional view showing a configuration of a plate portion of a stage according to an embodiment of the present invention.
FIG. 16 is a schematic cross-sectional view showing a configuration of a plate portion of a stage according to an embodiment of the present invention.
FIG. 17 is a schematic cross-sectional view showing a configuration of a plate portion of a stage according to an embodiment of the present invention.
FIG. 18 is a schematic cross-sectional view showing a configuration of a plate portion of a stage according to an embodiment of the present invention.
FIG. 19 is a schematic cross-sectional view showing a configuration of a plate portion of a stage according to an embodiment of the present invention.
FIG. 20 is a schematic cross-sectional view showing a configuration of a plate portion of a stage according to an embodiment of the present invention.
FIG. 21 is a schematic cross-sectional view showing a configuration of a plate portion of a stage according to an embodiment of the present invention.
FIG. 22 is a schematic cross-sectional view showing a configuration of a plate portion of a stage according to an embodiment of the present invention.
FIG. 23 is a graph illustrating a temperature gradient profile of a stage according to an embodiment of the present invention.
FIG. 24 is a schematic cross-sectional view showing a configuration of a plate portion of a stage according to an embodiment of the present invention.
FIG. 25 is a schematic cross-sectional view showing a configuration of a plate portion of a stage according to an embodiment of the present invention.
FIG. 26 is a schematic cross-sectional view showing a configuration of an etching apparatus according to an embodiment of the present invention.
FIG. 27 is a schematic cross-sectional view showing a configuration of a CVD apparatus according to an embodiment of the present invention.
FIG. 28 is a schematic cross-sectional view showing a configuration of a sputtering apparatus according to an embodiment of the present invention.
FIG. 29 is a schematic cross-sectional view showing a configuration of an evaporation apparatus according to an embodiment of the present invention.

### DESCRIPTION OF EMBODIMENTS

Hereinafter, embodiments of the invention disclosed in the present application are described with reference to the drawings. However, the present invention can be implemented in various forms without departing from the gist thereof and should not be construed as being limited to the description of the following exemplary embodiments.

For the sake of clarity of description, the drawings may be schematically represented with respect to widths, thicknesses, shapes, and the like of the respective portions compared with actual embodiments. However, the drawings are merely an example and do not limit the interpretation of the present invention. In the present specification and the respective drawings, components having the same functions as those described with reference to the preceding drawings are denoted by the same reference numerals, and a duplicate description thereof may be omitted. Further, although the terms "upper" and "lower" are used in the explanation, the terms "upper" and "lower" respectively indicate the direction when the stage is in use (when a wafer is placed on the stage).

In the specification and the drawings, the same reference numerals are used when multiple components are identical or similar in general, and reference numerals with a lower or upper case letter of the alphabet are used when the multiple components are distinguished. Further, reference numerals with a hyphen and a natural number are used when multiple portions of one component are distinguished.

In the present specification, an "inner region" of a stage refers to a region inside and surrounded by a heat insulating portion and a region overlapping the region. Further, in the present specification, an "outer region" of the stage refers to a region outside the inner region. In other words, the "outer region" is a region on an outer periphery of the stage. In addition, although in the present specification, the terms "inner region" and "outer region" are used not only for the stage but also for the wafer, the "inner region" and the "outer region" of the wafer refer to regions that overlap with the "inner region" and the "outer region" of the stage, respectively when the wafer is placed on the stage.

### <First Embodiment>

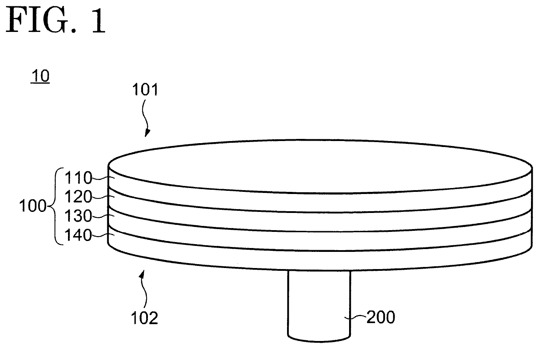

A stage 10 according to an embodiment of the present invention is described with reference to FIGS. 1 to 8.

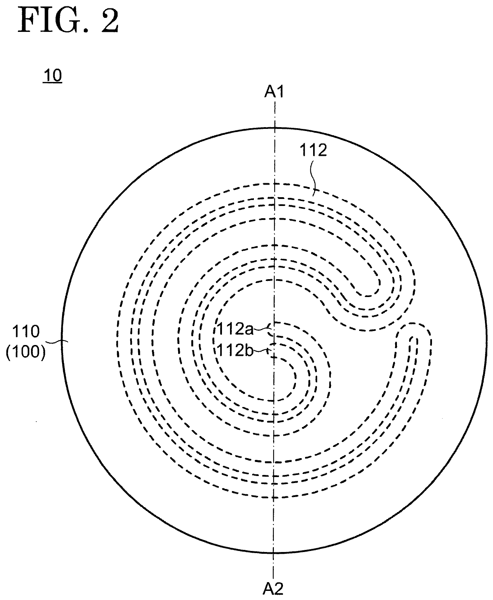

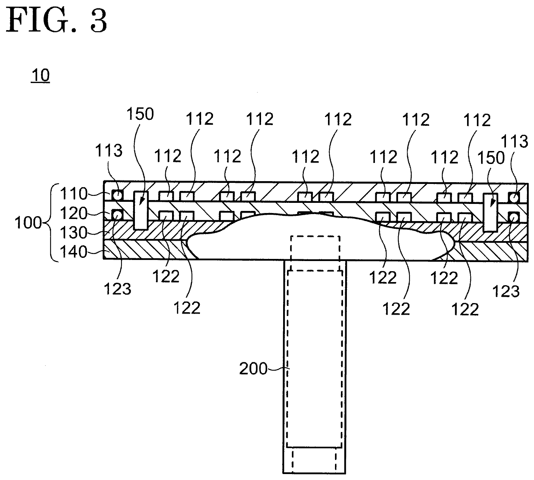

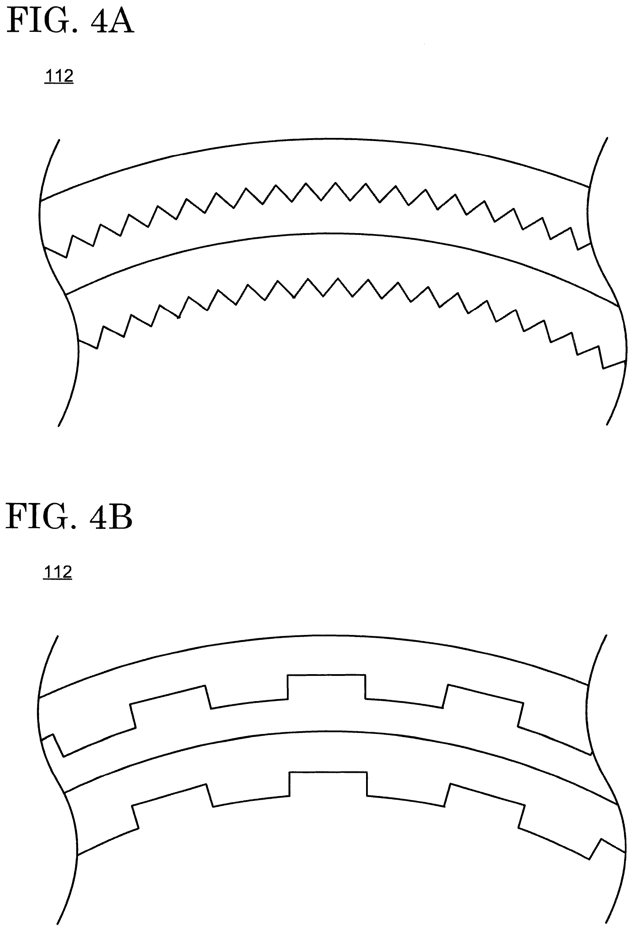

FIG. 1 is a schematic perspective view showing a configuration of the stage 10 according to an embodiment of the present invention. FIG. 2 is a schematic top view showing the configuration of the stage 10 according to an embodiment of the present invention. In FIG. 2, a circulating flow path 112, which is described later, is indicated by a dotted line. FIG. 3 is a cross-sectional view showing the configuration of the stage 10 according to an embodiment of the present invention. Specifically, FIG. 3 is a cross-sectional view showing a cross section of a portion of the stage 10 taken along the line A1-A2 shown in FIG. 2. Each of FIGS. 4A and 4B is a schematic cross-sectional view showing a configuration of the circulating flow path 112 of the stage 10 according to an embodiment of the present invention.

As shown in FIG. 1, the stage 10 includes a plate portion 100 and a shaft portion 200. In the stage 10, a wafer is placed on a first surface 101 of the plate portion 100. The shaft portion 200 is connected to a second surface 102 of the plate portion 100 opposite to the first surface 101.

For example, although silicon (Si), silicon carbide (SiC), sapphire, quartz, glass, gallium phosphide (GaP), gallium arsenide (GaAs), indium phosphide (InP), or gallium nitride (GaN) is used for the wafer placed on the stage 10, a material of the wafer is not limited thereto. As described above, since the wafer is placed on the first surface 101 of the plate portion 100, the first surface 101 may be provided with a step for guiding the wafer to be placed.

The plate portion 100 includes a first metal plate 110, a second metal plate 120, a third metal plate 130, and a fourth metal plate 140. The first metal plate 110 to the fourth metal plate 140 are stacked in this order. That is, the second metal plate 120 is located below the first metal plate 110, the third metal plate 130 is located below the second metal plate 120, and the fourth metal plate 140 is located below the third metal plate 130.

The first metal plate 110 and the second metal plate 120, the second metal plate 120 and the third metal plate 130, and the third metal plate 130 and the fourth metal plate 140 are bonded to each other by welding, screwing, solid-state diffusion bonding, or brazing, etc. For example, an alloy containing silver, copper, and zinc, an alloy containing copper and zinc, copper containing a trace amount of phosphorus, an alloy containing aluminum, an alloy containing titanium, copper, and nickel, an alloy containing titanium, zirconium, and copper, or an alloy containing titanium, zirconium, copper, and nickel can be used as the brazing material.

As shown in FIG. 2, the first metal plate 110 has a circular shape when viewed from above. The second metal plate 120 to the fourth metal plate 140 overlapping the first metal plate 110 also have a circular shape. However, the shapes of the first metal plate 110 to the fourth metal plate 140 are not limited to a circular shape. The shapes of the first metal plate 110 to the fourth metal plate 140 may be appropriately determined according to the shape of the wafer, and the first metal plate 110 to the fourth metal plate 140 may have an elliptical shape or a polygonal shape.

Further, the thicknesses of the first metal plate 110 to the fourth metal plate 140 may be the same or different.

For example, a metal such as aluminum, titanium, iron, copper, nickel, molybdenum, tungsten, or gold, or an alloy containing these metals is used as a material of the first metal plate 110 to the fourth metal plate 140. The alloy containing iron is, for example, stainless steel, Kovar, or 42 alloy. The alloy containing nickel is, for example, Inconel or Hastelloy. As described later, the first metal plate 110 is provided with a circulating flow path 112 through which a cooling medium flows, and a heater 113. The surface of the first metal plate 110 corresponds to the first surface 101 of the plate portion 100, and the wafer is placed on the surface of the first metal plate 110. Therefore, it is preferable to use a material with high thermal conductivity for the first metal plate 110 in order to efficiently conduct the heat generated by the heater 113 to the wafer and efficiently absorb the heat by the cooling medium flowing through the circulation flow path 112. For example, a metal or alloy having a thermal conductivity greater than or equal to 200 W/mK and less than or equal to 430 W/mK can be used as the material of the first metal plate 110. The first metal plate 110 to the fourth metal plate 140 may be made of the same material or different materials. When the first metal plate 110 to the fourth metal plate 140 are different, it is preferable that the metal or alloy contained in the first metal plate 110 to the fourth metal plate 140 has a thermal expansion coefficient greater than or equal to 5×10⁻⁶ /K and less than or equal to 25×10⁻⁶ /K. Further, it is preferable that the materials of the two adjacent metal plates are selected so that the difference in the thermal expansion coefficient is less than or equal to 10×10⁻⁶ /K. Thus, since a deformation of the stage 10 due to differences in thermal expansion is suppressed, the reliability of the stage 10 can be improved.

As shown in FIG. 3, the first metal plate 110 includes the circulating flow path 112 and the heater 113. The circulating flow path 112 and the heater 113 of the first metal plate 110 are provided on the side of the second metal plate 120, and are closed by the second metal plate 120. Further, the circulating flow path 112 is provided in an inner region of the plate portion 100, and the heater 113 is provided in an outer region of the plate portion 100.

Further, the second metal plate 120 also includes a circulating flow path 122 and a heater 123. The circulating flow path 122 and the heater 123 of the second metal plate 120 are provided on the side of the third metal plate 130, and are closed by the third metal plate 130. The circulating flow path 122 is provided in the inner region of the plate portion 100, and the heater 123 is provided in the outer region of the plate portion 100.

In a plan view, the circulating flow path 112 overlaps the circulating flow path 122. Further, the heater 113 overlaps the heater 123 in a plan view.

A cooling medium including a liquid such as water or a gas, is introduced into the circulating flow path 112 from an inlet 112a, and after circulating widely through the first metal plate 110 along the circulating flow path 112, the cooling medium is discharged from an outlet 112b to the outside of the first metal plate 110 (see FIG. 2). The circulation of the cooling medium causes heat exchange between the cooling medium and the plate portion 100 or the wafer, and the inner region of the wafer is cooled. The circulating flow path 112 may be a structure formed directly in the first metal plate 110, or may be a structure in which a tubular member is disposed in a groove provided in the first metal plate 110.

In a plan view, although the circulating flow path 112 shown in FIG. 2 has a smoothly curved shape (i.e., the side surface of the circulating flow path 112 has a smoothly curved surface), the configuration of the circulating flow path 112 is not limited thereto. For example, as shown in FIG. 4A, the circulating flow path 112 may have a zigzag shape in a plan view. Further, as shown in FIG. 4B, the circulating flow path 112 may have an uneven shape in a plan view. In other words, the width of the circulating flow path 112 may not be constant in the circumferential direction, and may vary.

The circulating flow path 122 has a similar configuration to the circulating flow path 112. However, the shape of the circulating flow path 112 and the shape of the circulating flow path 122 may be different from each other. Further, the conditions (e.g., type, temperature, flow rate, etc.) of the cooling medium flowing through the circulating flow path 122 may be the same as or different from the conditions of the cooling medium flowing through the circulating flow path 122. In other words, the conditions of the cooling medium for the circulating flow path 112 and the circulating flow path 122 can be controlled independently.

The heater 113 is driven under the control of a control device (not shown in the figures). For example, the heater 113 is configured using an electric heating wire and is arranged along the outer periphery of the first metal plate 110. The heater 113 may be embedded in the first metal plate 110, or may be arranged in a groove provided in the first metal plate 110. For example, the heater 113 can be located on the first metal plate 110 by covering the heater 113 with a sprayed film or the like after arranging the heater 113 in the groove of the first metal plate 110. The heater 113 heats the outer region of the wafer through the first metal plate 110.

The heater 123 has a similar configuration to the heater 113. However, the heater 123 may be different from the heater 113 in type, cross-sectional diameter, power density, or the like. Further, the heater 123 can be controlled independently of the heater 113. That is, the heater 113 and the heater 123 are electrically insulated from each other.

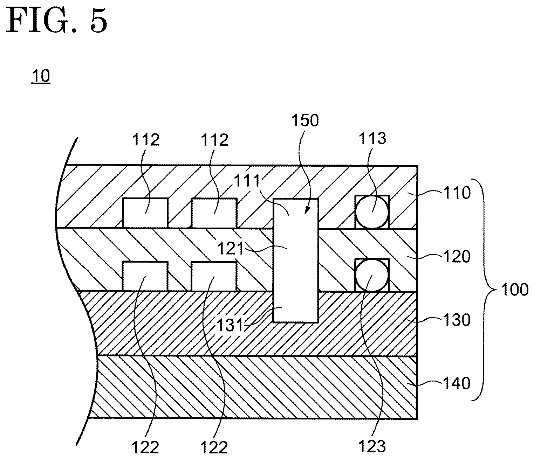

In the plate portion 100, a heat insulating portion 150 is provided between the circulating flow path 112 arranged in the inner region of the first metal plate 110 (or the circulating flow path 112 arranged in the inner region of the second metal plate 120) and the heater 113 arranged in the outer region of the first metal plate 110 (or the heater 113 arranged in the outer region of the second metal plate 120). Here, a configuration of the plate portion 100 is described with reference to FIGS. 5 to 7.

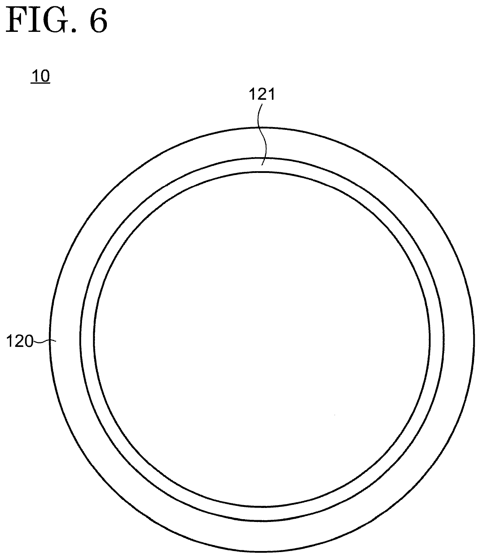

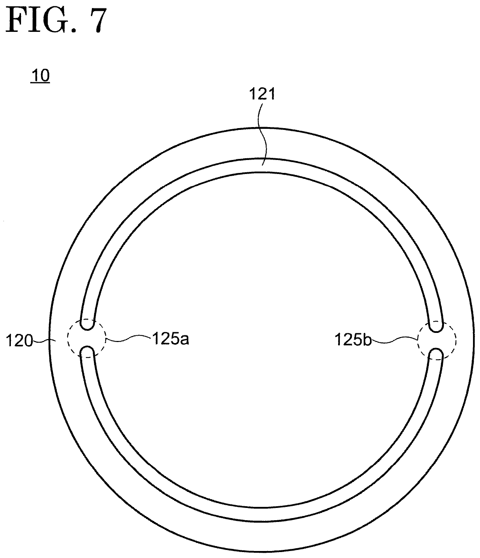

FIG. 5 is a schematic cross-sectional view showing the configuration of the plate portion 100 of the stage 10 according to an embodiment of the present invention. FIGS. 6 and 7 are schematic plan views showing a configuration of the second metal plate 120 of the stage 10 according to an embodiment of the present invention. Specifically, FIGS. 6 and 7 are top views of the second metal plate 120.

As shown in FIG. 5, the heat insulating portion 150 includes a first groove 111 formed in the first metal plate 110, a through hole 121 formed in the second metal plate 120, and a second groove 131 formed in the third metal plate 130. The first groove 111, the through hole 121, and the second groove 131 overlap each other. The first groove 111 has an opening surface on the side of the second metal plate 120. The through hole 121 penetrates the second metal plate 120 and has opening surfaces on the side of first metal plate 110 and on the side of the third metal plate 130. The second groove 131 has an opening surface on the side of the second metal plate 120. The opening surface of the first groove 111 approximately coincides with the opening surface of one end of the through hole 121, and the opening surface of the second groove 131 approximately coincides with the opening surface of the other end of the through hole 121. That is, the heat insulating portion 150 has a structure in which the first groove 111, the through hole 121, and the second groove 131 are connected to one another. In other words, the heat insulating portion 150 has a closed space that penetrates the second metal plate 120, has an upper surface formed in the first metal plate 110, and has a bottom surface formed in the third metal plate. The heat insulating portion 150 may be in a vacuum or may be filled with a liquid or gas. Further, the heat insulating portion 150 may be connected to an external vacuum pump or the like to adjust the pressure, temperature, or gas flow rate. An inert gas such as helium gas, argon gas, or nitrogen gas may be used as the gas filled in the heat insulating portion 150 or circulating in the heat insulating portion 150. Furthermore, the heat insulating portion 150 may be filled with a heat insulating material.

In a plan view, the first groove 111, the through hole 121, and the second groove 131 are formed circumferentially in the first metal plate 110, the second metal plate 120, and the third metal plate 130, respectively. As shown in FIG. 6, the through hole 121 is also provided circumferentially in the second metal plate 120. That is, the inner region and the outer region are separated in the second metal plate 120. In this case, the second metal plate 120 is arranged so that the separated inner region and outer region of the second metal plate 120 are not in contact with each other when the second metal plate 120 is bonded to the first metal plate 110 or the third metal plate 130, and is bonded to the first metal plate 110 or the third metal plate 130. However, when the through hole 121 formed in the second metal plate 120 is provided over the entire circumference so as to separate the inner region of the second metal plate 120 from the outer region, it may be difficult to handle the second metal plate 120 when bonding the second metal plate 120. Therefore, as shown in FIG. 7, the second metal plate 120 may be provided with connection regions 125a and 125b that connect the inner region and the outer region. Since the connection regions 125a and 125b can be a heat conduction path, it is preferable that the widths of the connection regions 125a and 125b are as small as possible. Further, although two connection regions 125a and 125b are shown in FIG. 7, it is sufficient that the second metal plate 120 is provided with at least one connection region 125. The number of connection regions 125 corresponds to the number of through holes 121. For example, when the second metal plate 120 is provided with three connection regions 125, the second metal plate 120 has three through holes 121.

Further, each of the first groove 111 and the second groove 131 may also be divided into a plurality of grooves.

The heat insulating portion 150 is located between the circulating flow paths 112 and 122 in the inner region and the heaters 113 and 123 in the outer region. The heat insulating portion 150 is provided across the first metal plate 110, the second metal plate 120, and the third metal plate 130, and has a large space. Therefore, the heat insulating portion 150 can suppress heat conduction from the inner region to the outer region and heat conduction from the outer region to the inner region not only in the first metal plate 110 but also in the second metal plate 120 and the third metal plate 130. Thus, a large temperature difference between the inner region and the outer region can be achieved in the stage 10.

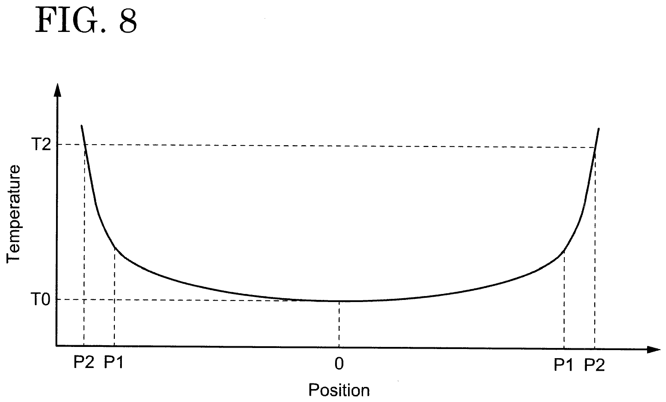

FIG. 8 is a graph illustrating a temperature gradient profile of the stage 10 according to an embodiment of the present invention.

In FIG. 8, the horizontal axis indicates the position of the surface of the first metal plate 110 along a predetermined direction (for example, the direction of the line A1-A2) with the center position of the surface of the first metal plate 110 being zero, and the vertical axis indicates the surface temperature of the surface of the first metal plate 110. The first position P1 and the second position P2 represent the positions of the heat insulating portion 150 and the heater 113, respectively. That is, the region between the two P1s corresponds to the inner region, and the region between the P1 and the P2 corresponds to the outer region.

In the stage 10, the inner region of the first metal plate 110 is cooled by the cooling medium flowing through the circulating flow paths 112 and 122 in the inner regions of the first metal plate 110 and the second metal plate 120. Meanwhile, the outer region of the first metal plate 110 is heated by the heaters 113 and 123 in the outer regions of the first metal plate 110 and the second metal plate 120. The heat of the outer region of the first metal plate 110 is conducted to the inner region. However, since the heat insulating portion 150 is provided between the inner region and the outer region, the heat conduction path between the inner region and the outer region is restricted, and the heat conduction from the outer region to the inner region is suppressed. Therefore, even when the outer region is heated by the heaters 113 and 123, the temperature rise in the inner region is suppressed. Further, the temperature difference between the inner region and the outer region increases due to the reduction in the heat flow rate caused by the heat insulating portion 150. For example, the maximum temperature difference between the minimum surface temperature T0 measured near the center of the first metal plate 110 and the maximum surface temperature T2 measured near the heater 113 is higher than or equal to 20°C, preferably greater than or equal to 60°C, and more preferably greater than or equal to 100°C. The temperature difference between the inner region and the outer region of the stage 10 can be adjusted by changing the power supplied to the heaters 113 and 123 or the conditions of the cooling medium flowing through the circulating flow paths 112 and 122. As described above, in the stage 10, the heaters 113 and 123 can be controlled independently, and the conditions of the cooling medium can also be controlled independently. Therefore, in the stage 10, the temperature difference between the inner region and the outer region can be increased while adjusting the temperature of the inner region and the temperature of the outer region.

A flow path (not shown in figures) through which the cooling medium flows is formed inside the shaft portion 200. Specifically, the shaft portion 200 feeds the cooling medium to the inlet 112a through a flow path and receives the cooling medium discharged from the outlet 112b. One end of the shaft portion 200 is connected to the second surface 102 of the plate portion 100. The other end of the shaft portion 200 is connected to a supply source of the cooling medium. For example, although the supply source may be a tank and pump that hold the cooling medium, or a water pipe, the supply source is not limited thereto.

Further, a lead wire of the heater 113 may be stored inside the shaft portion 200. Furthermore, in the case where an electrostatic chuck is provided, a wiring connected to the electrostatic chuck may be stored inside the shaft portion 200.

Moreover, the shaft portion 200 may be connected to a rotation mechanism. When the shaft portion 200 is connected to the rotation mechanism, the stage 10 can be rotated around the major axis of the shaft portion 200.

Although the configuration of the stage 10 is described above, the advantages of the stage 10 compared to a conventional stage are described in the following description.

In the process of the semiconductor apparatus, the wafer placed on the stage may be heated, and in that case, it is required to make the temperature distribution in the wafer uniform. In the conventional stage, the temperature of the outer region may be lower than that of the inner region when heated. Further, the temperature of the inner region of the wafer placed on the stage may increase, depending on the semiconductor apparatus. For example, when a film is deposited on a wafer in a CVD (Chemical Vapor Deposition) apparatus or an ALD (Atomic Layer Deposition) apparatus, the application of plasma causes a local temperature increase in the center of the wafer, and the temperature of the inner region of the wafer becomes higher than that of the outer region of the wafer. Therefore, a significant temperature drop is observed in the outer region of the wafer in the conventional stage.

On the other hand, in a semiconductor apparatus using the stage 10, the temperature difference between the inner region and the outer region of the stage 10 is large, and the significant temperature drop described above can be corrected to uniformize the temperature distribution in the wafer. In particular, since the stage 10 can obtain a temperature difference larger than the temperature difference at which cracks occur due to ceramics, the stage 10 can be applied to more semiconductor apparatuses than the stage using ceramics.

However, the thermal expansion coefficient of the metal or alloy contained in the first metal plate 110 to the fourth metal plate 140 is relatively larger than that of ceramic. Therefore, in the conventional stage in which the heat insulating portion 150 is not provided and the temperature difference between the inner region and the outer region is increased by simply controlling the circulating flow path 112 and the heater 113, the stage may be deformed by thermal stress. In other words, in the case of the conventional stage in which the heat insulating portion 150 is not provided, the stage is deformed by thermal stress, so that the temperature difference between the inner region and the outer region of the stage 10 cannot be increased. Meanwhile, since the space of the heat insulating portion 150 contracts or expands in the stage 10, the thermal stress is relaxed. That is, the heat insulating portion 150 functions as a damper that absorbs the thermal stress caused by the temperature difference between the inner region and the outer region of the stage. Further, the heat insulating portion 150 is provided across the first metal plate 110, the second metal plate 120, and the third metal plate 130 in the stage 10. As a result, in the stage 10, not only the thermal stress in the first metal plate 110 on which the heater 113 is provided and the second metal plate 120 on which the heater 123 is provided, but also the thermal stress in the third metal plate 130 to which the heat from the heaters 113 and 123 is conducted is relaxed, so that the stage 10 is less likely to deform even when the temperature difference between the inner region and the outer region is increased.

As described above, the heat insulating portion 150 can suppress the heat from the heaters 113 and 123 provided in the outer region from being conducted to the inner region in the stage 10. That is, since the cross-sectional area of the heat conduction path connecting the outer region and the inner region of the plate portion 100 is reduced by the space formed by the heat insulating portion 150, the heat insulating portion 150 can function as a thermal blockage / thermal choke. As a result, since the temperature difference between the inner region and the outer region becomes large in the stage 10, the temperature of the outer region of the wafer can be corrected and the temperature distribution in the wafer can be made uniform, for example, when the stage 10 is applied to the wafer in which the temperature drop in the outer region is significant.

Several modifications of the stage 10 according to an embodiment of the present invention are described in the following description. In addition, the modifications of the configuration of the stage 10 are not limited to the modifications described below.

### <Modification 1>

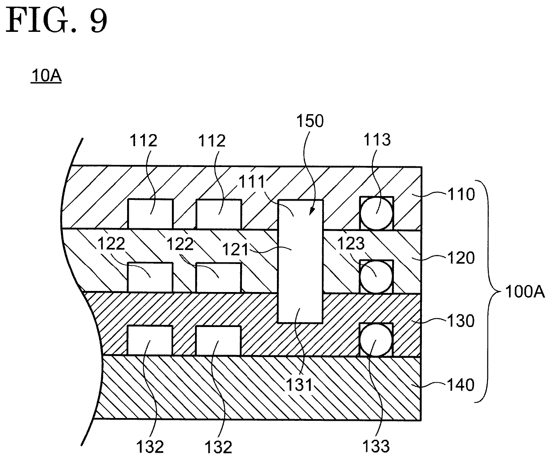

A modification of the stage 10 according to an embodiment of the present invention is described with reference to FIG. 9. In addition, a description of a configuration that is the same as or similar to the configuration of the stage 10 may be omitted in the following description.

FIG. 9 is a schematic cross-sectional view showing a configuration of a plate portion 100A of a stage 10A according to an embodiment of the present invention.

As shown in FIG. 9, the plate portion 100A of the stage 10A includes the first metal plate 110, the second metal plate 120, the third metal plate 130, and the fourth metal plate 140. The first metal plate 110 is provided with the first groove 111, the circulating flow path 112, and the heater 113. The second metal plate 120 is provided with the through hole 121, the circulating flow path 122, and the heater 123. The third metal plate 130 is provided with the second groove 131, a circulating flow path 132, and a heater 133. That is, in the stage 10A, the third metal plate 130 is also provided with the circulating flow path 132 and the heater 133, similar to the first metal plate 110 and the second metal plate 120. The circulating flow path 132 and the heater 133 are arranged with the heat insulating portion 150 sandwiched therebetween.

In the inner region of the stage 10A, the circulating flow paths 112, 122, and 132 overlap one another. In the outer region of the stage 10A, the heaters 113, 123, and 133 overlap one another. In the stage 10A, the heaters 113, 123, and 133 can be controlled independently, and the conditions of the cooling medium flowing through the circulating flow paths 112, 122, and 132 can also be controlled independently. Therefore, in the stage 10A, the temperature difference between the inner region and the outer region can be increased while adjusting the temperature of the inner region and the temperature of the outer region.

### <Modification 2>

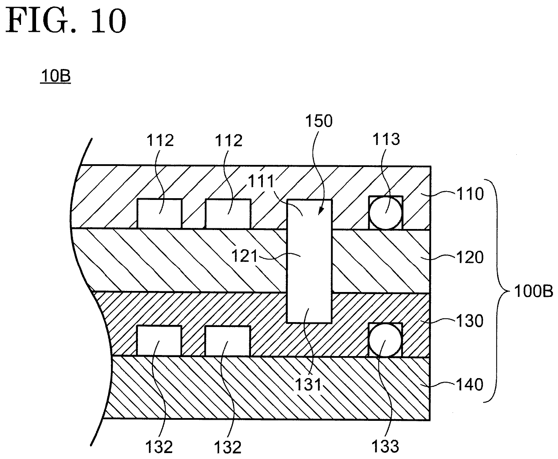

Another modification of the stage 10 according to an embodiment of the present invention is described with reference to FIG. 10. In addition, a description of a configuration that is the same as or similar to the configuration of the stage 10 or stage 10A may be omitted in the following description.

FIG. 10 is a schematic cross-sectional view showing a configuration of a plate portion 100B of a stage 10B according to an embodiment of the present invention.

As shown in FIG. 10, the plate portion 100B of the stage 10B includes the first metal plate 110, the second metal plate 120, the third metal plate 130, and a fourth metal plate 140. The first metal plate 110 is provided with the first groove 111, the circulating flow path 112, and the heater 113. The second metal plate 120 is provided with the through hole 121. The third metal plate 130 is provided with the second groove 131, the circulating flow path 132, and the heater 133. That is, in the stage 10B, the first metal plate 110 and the third metal plate 130 are provided with the circulating flow paths 112 and 132 and the heaters 113 and 133, and the second metal plate 120 is not provided with a circulating flow path or a heater.

In the inner region of the stage 10B, the circulating flow paths 112 and 132 overlap each other. In the outer region of the stage 10B, the heaters 113 and 133 overlap each other. In the stage 10B, the heaters 113 and 133 can be controlled independently, and the conditions of the cooling medium flowing through the circulating flow paths 112 and 132 can also be controlled independently. In the stage 10B, when a sufficient temperature difference between the inner region and the outer region is obtained by the heater 113 provided on the first metal plate 110 and the cooling medium flowing through the circulating flow path 112, the first metal plate 110 is heated by the heater 133 through the second metal plate 120, or the first metal plate 110 is cooled by the cooling medium flowing through the circulating flow path 132, thereby adjusting the temperature difference between the inner region and the outer region.

### <Modification 3>

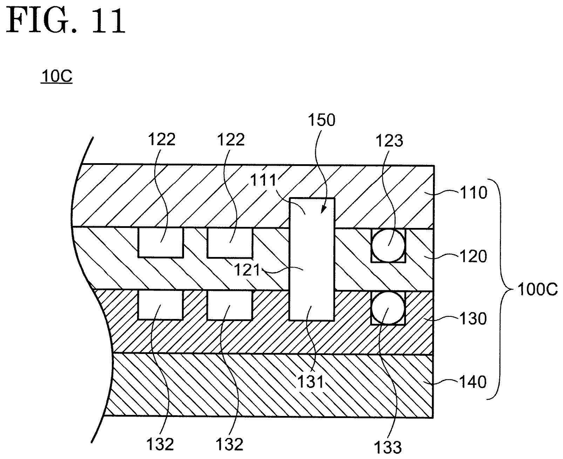

Another modification of the stage 10 according to an embodiment of the present invention is described with reference to FIG. 11. In addition, a description of a configuration that is the same as or similar to the configurations of the stages 10 to 10B may be omitted in the following description.

FIG. 11 is a schematic cross-sectional view showing a configuration of a plate portion 100C of a stage 10C according to an embodiment of the present invention.

As shown in FIG. 11, the plate portion 100C of the stage 10C includes the first metal plate 110, the second metal plate 120, the third metal plate 130, and the fourth metal plate 140. The first metal plate is provided with the first groove 111. The second metal plate 120 is provided with the through hole 121, the circulating flow path 122, and the heater 123. The third metal plate 130 is provided with the second groove 131, the circulating flow path 132, and the heater 133. That is, in the stage 10C, the second metal plate 120 and the third metal plate 130 are provided with the circulating flow paths 122 and 132 and the heaters 123 and 133, and the first metal plate 110 is not provided with a circulating flow path or a heater.

In the inner region of the stage 10C, the circulating flow paths 122 and 132 overlap each other. In the outer region of the stage 10C, the heaters 123 and 133 overlap each other. In the stage 10C, the heaters 123 and 133 can be controlled independently, and the conditions of the cooling medium flowing through the circulating flow paths 122 and 132 can also be controlled independently. Since the heater 123 heats the outer region of the first metal plate 110, and the cooling medium flowing through the circulating flow path 122 cools the inner region of the first metal plate 110 in the stage 10C, the temperature difference between the inner region and the outer region is increased. Further, the temperature difference between the inner region and the outer region can be adjusted by controlling the heater 133 of the third metal plate 130 and the cooling medium flowing through the circulating flow path 132.

### <Modification 4>

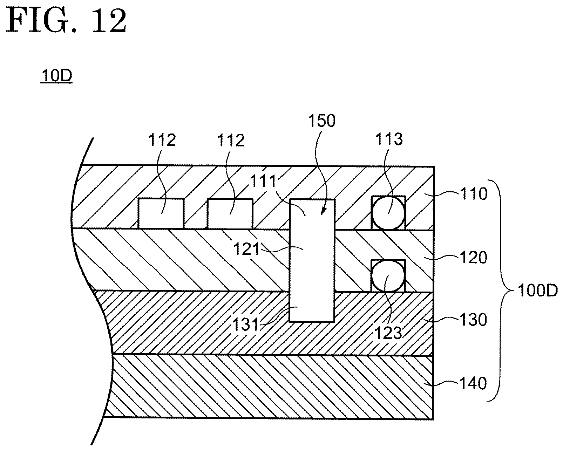

Another modification of the stage 10 according to an embodiment of the present invention is described with reference to FIG. 12. In addition, a description of a configuration that is the same as or similar to the configuration of the stage 10 to 10C may be omitted in the following description.

FIG. 12 is a schematic cross-sectional view showing a configuration of a plate portion 100D of a stage 10D according to an embodiment of the present invention.

As shown in FIG. 12, the plate portion 100D of the stage 10D includes the first metal plate 110, the second metal plate 120, the third metal plate 130, and the fourth metal plate 140. The first metal plate 110 is provided with the first groove 111, the circulating flow path 112, and the heater 113. The second metal plate 120 is provided with the through hole 121 and the heater 123. The third metal plate 130 is provided with the second groove 131. That is, in the stage 10D, the first metal plate 110 is provided with the circulating flow path 112 and the heater 113, and the third metal plate 130 is not provided with a circulating flow path or a heater. Further, although the second metal plate 120 is provided with the heater 123, the second metal plate 120 is not provided with a circulating flow path.

In the outer region of the stage 10D, the heaters 113 and 123 overlap each other. In the stage 10D, the heaters 113 and 123 can be controlled independently. Since the heater 113 heats the outer region of the first metal plate 110, and the cooling medium flowing through the circulating flow path 112 cools the inner region of the first metal plate 110 in the stage 10D, the temperature difference between the inner region and the outer region is increased. Further, the temperature of the outer region can be further adjusted by controlling the heater 123 of the second metal plate 120.

### <Modification 5>

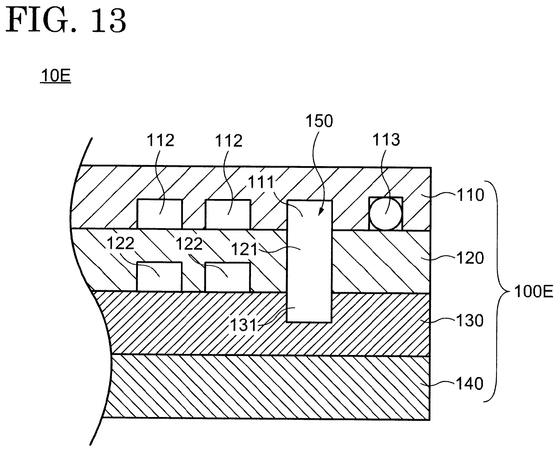

Another modification of the stage 10 according to an embodiment of the present invention is described with reference to FIG. 13. In addition, a description of a configuration that is the same as or similar to the configuration of the stage 10 to 10D may be omitted in the following description.

FIG. 13 is a schematic cross-sectional view showing a configuration of a plate portion 100E of a stage 10E according to an embodiment of the present invention.

As shown in FIG. 13, the plate portion 100E of the stage 10E includes the first metal plate 110, the second metal plate 120, the third metal plate 130, and the fourth metal plate 140. The first metal plate 110 is provided with the first groove 111, the circulating flow path 112, and the heater 113. The second metal plate 120 is provided with the through hole 121. The third metal plate 130 is provided with the second groove 131, the circulating flow path 132, and the heater 133. That is, in the stage 10E, the first metal plate 110 is provided with the circulating flow path 112 and the heater 113, and the third metal plate 130 is not provided with a circulating flow path or a heater. Further, although the second metal plate 120 is provided with the circulating flow path 122, the second metal plate 120 is not provided with a heater.

In the inner region of the stage 10E, the circulating flow paths 112 and 122 overlap each other. In the stage 10E, the conditions of the cooling medium flowing through the circulating flow paths 112 and 122 can be controlled independently. Since the heater 113 heats the outer region of the first metal plate 110, and the cooling medium flowing through the return channel 112 cools the inner region of the first metal plate 110 in the stage 10E, the temperature difference between the inner region and the outer region is increased. Further, the temperature of the inner region can be further adjusted by controlling the conditions of the cooling medium flowing through the circulating flow path 122 of the second metal plate 120.

### <Modification 6>

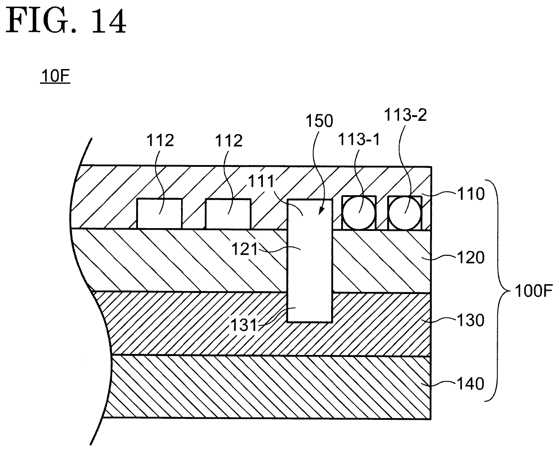

Another modification of the stage 10 according to an embodiment of the present invention is described with reference to FIG. 14. In addition, a description of a configuration that is the same as or similar to the configuration of the stage 10 to 10E may be omitted in the following description.

FIG. 14 is a schematic cross-sectional view showing a configuration of a plate portion 100F of a stage 10F according to an embodiment of the present invention.

As shown in FIG. 14, the plate portion 100F of the stage 10F includes the first metal plate 110, the second metal plate 120, the third metal plate 130, and the fourth metal plate 140. The first metal plate 110 is provided with the first groove 111, the circulating flow path 112, a first heater 113-1, and a second heater 113-2. The second metal plate 120 is provided with the through hole 121. The third metal plate 130 is provided with the second groove 131. That is, in the stage 10F, the first metal plate 110 is provided with the circulating flow path 112, the first heater 113-1, and the second heater 113-2, and the second metal plate 120 and the third metal plate 130 are not provided with a circulating flow path or a heater.

In the stage 10F, the first heater 113-1 and the second heater 113-2 can be controlled independently. That is, the first heater 113-1 and the second heater 11302 are electrically insulated from each other. Since the first heater 113-1 heats the outer region of the first metal plate 110, and the cooling medium flowing through the circulating flow path 112 cools the inner region of the first metal plate in the stage 10F, the temperature difference between the inner region and the outer region is increased. Further, the temperature of the outer region can be further adjusted by controlling the second heater 113-2 of the first metal plate 110.

### <Modification 7>

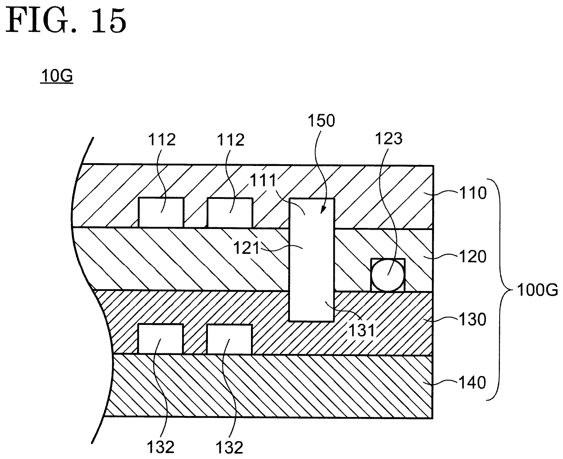

Another modification of the stage 10 according to an embodiment of the present invention is described with reference to FIG. 15. In addition, a description of a configuration that is the same as or similar to the configuration of the stage 10 to 10F may be omitted in the following description.

FIG. 15 is a schematic cross-sectional view showing a configuration of a plate portion 100G of a stage 10G according to an embodiment of the present invention.

As shown in FIG. 15, the plate portion 100G of the stage 10G includes the first metal plate 110, the second metal plate 120, the third metal plate 130, and the fourth metal plate 140. The first metal plate 110 is provided with the first groove 111 and the circulating flow path 112. The second metal plate 120 is provided with the through hole 121 and the heater 123. The third metal plate 130 is provided with the second groove 131 and the circulating flow path 132. That is, in the stage 10G, each of the first metal plate 110 to the third metal plate 130 is provided with either a circulating flow path or a heater.

In the inner region of the stage 10G, the circulating flow paths 112 and 132 overlap each other. In the stage 10G, the conditions of the cooling medium flowing through the circulating flow paths 112 and 132 can be controlled independently. Since the heater 123 heats the outer region of the first metal plate 110, and the cooling medium flowing through the circulating flow path 112 cools the inner region of the first metal plate 110 in the stage 10G, the temperature difference between the inner region and the outer region is increased. Further, the temperature of the outer region can be further adjusted by controlling the conditions of the cooling medium flowing through the circulating flow path 132 of the third metal plate 130.

In addition, although the plate portion 100G including two circulating flow paths and one heater is described in the Modification 7, the plate portion may also include one circulating flow path and two heaters. In this case, the temperature of the outer region can be adjusted by controlling one of the two heaters. The two circulating flow paths or the two heaters may be disposed on two adjacent metal plates, respectively, or may be disposed on two separate metal plates, respectively.

### <Modification 8>

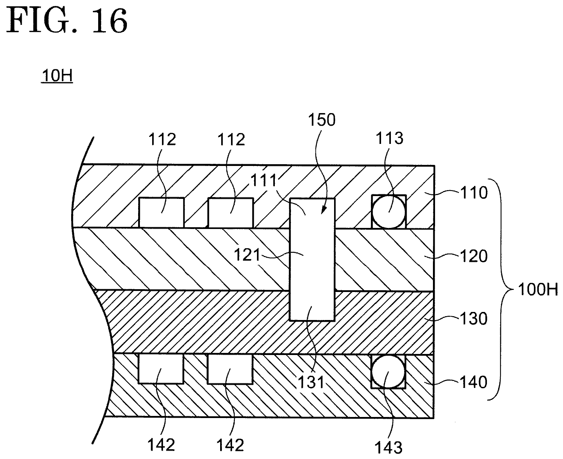

Another modification of the stage 10 according to an embodiment of the present invention is described with reference to FIG. 16. In addition, a description of a configuration that is the same as or similar to the configuration of the stage 10 to 10G may be omitted in the following description.

FIG. 16 is a schematic cross-sectional view showing a configuration of a plate portion 100H of a stage 10H according to an embodiment of the present invention.

As shown in FIG. 16, the plate portion 100H of the stage 10H includes the first metal plate 110, the second metal plate 120, the third metal plate 130, and the fourth metal plate 140. The first metal plate 110 is provided with the first groove 111, the circulating flow path 112, and the heater 113. The second metal plate 120 is provided with the through hole 121. The third metal plate 130 is provided with the second groove 131. The fourth metal plate 140 is provided with a circulating flow path 142 and a heater 143. That is, in the stage 10H, at least one of the circulating flow path and the heater is provided in the fourth metal plate 140 connected to the shaft portion 200.

In the inner region of the stage 10H, the circulating flow paths 112 and 142 overlap each other. In the outer region of the stage 10H, the heaters 113 and 143 overlap each other. In the stage 10H, the heaters 113 and 143 can be controlled independently, and the conditions of the cooling medium flowing through the circulating flow paths 112 and 142 can also be controlled independently. Since the heater 113 heats the outer region of the first metal plate 110, and the cooling medium flowing through the circulating flow path 112 cools the inner region of the first metal plate 110 in the stage 10H, the temperature difference between the inner region and the outer region is increased. Further, the temperature difference between the inner region and the outer region can be adjusted by controlling the heater 143 of the fourth metal plate 140 and the cooling medium flowing through the circulating flow path 142.

### <Modification 9>

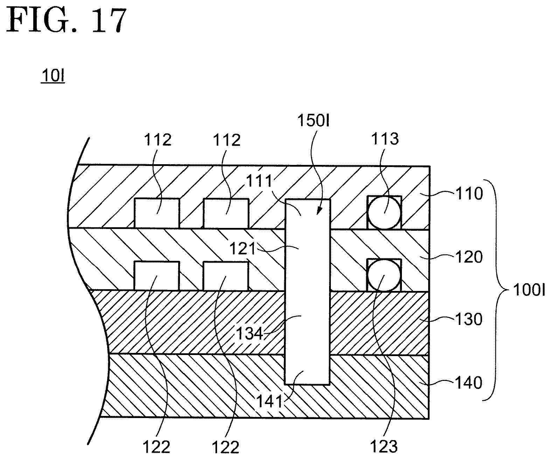

Another modification of the stage 10 according to an embodiment of the present invention is described with reference to FIG. 17. In addition, a description of a configuration that is the same as or similar to the configuration of the stage 10 to 10H may be omitted in the following description.

FIG. 17 is a schematic cross-sectional view showing a configuration of a plate portion 100l of a stage 10l according to an embodiment of the present invention.

As shown in FIG. 17, the plate portion 100l of the stage 10l includes the first metal plate 110, the second metal plate 120, the third metal plate 130, and the fourth metal plate 140. The first metal plate 110 is provided with the first groove 111, the circulating flow path 112, and the heater 113. The second metal plate 120 is provided with the first through hole 121, the circulating flow path 122, and the heater 123. The third metal plate 130 is provided with a second through hole 134. The fourth metal plate 140 is provided with a second groove 141. In the plate portion 100l, a heat insulating portion 150l is formed in which the first groove 111, the first through hole 121, the second through hole 134, and the second groove 141 are connected to one another. That is, in the stage 10l, the second groove 141 is provided in the fourth metal plate 140 connected to the shaft portion 200, and the heat insulating portion 150l is provided across the first metal plate 110 to the fourth metal plate 140.

In the inner region of the stage 10I, the circulating flow paths 112 and 122 overlap each other. In the outer region of the stage 10l, the heaters 113 and 123 overlap each other. In the stage 10l, the heaters 113 and 123 can be controlled independently, and the conditions of the cooling medium flowing through the circulating flow paths 112 and 122 can also be controlled independently. Since the heater 113 heats the outer region of the first metal plate 110, and the cooling medium flowing through the circulating flow path 112 cools the inner region of the first metal plate 110 in the stage 10l, the temperature difference between the inner region and the outer region is increased. Further, the temperature difference between the inner region and the outer region can be adjusted by controlling the heater 123 of the second metal plate 120 and the cooling medium flowing through the circulating flow path 122. In the stage 10l, since the insulating portion 150l is provided across the first metal plate 110 to the fourth metal plate 140, heat conduction from the inner region to the outer region and heat conduction from the outer region to the inner region can be further suppressed.

### <Modification 10>

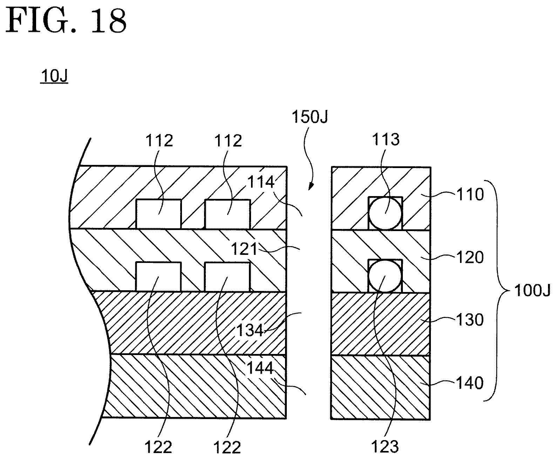

Another modification of the stage 10 according to an embodiment of the present invention is described with reference to FIG. 18. In addition, a description of a configuration that is the same as or similar to the configuration of the stage 10 to 10l may be omitted in the following description.

FIG. 18 is a schematic cross-sectional view showing a configuration of a plate portion 100J of a stage 10J according to an embodiment of the present invention.

As shown in FIG. 18, the plate portion 100J of the stage 10J includes the first metal plate 110, the second metal plate 120, the third metal plate 130, and the fourth metal plate 140. The first metal plate 110 is provided with a first through hole 114, the circulating flow path 112, and the heater 113. The second metal plate 120 is provided with the second through hole 121, the circulating flow path 122, and the heater 123. The third metal plate 130 is provided with a third through hole 134. The fourth metal plate 140 is provided with a fourth through hole 144. In the plate portion 100J, a heat insulating portion 150J is formed in which the first through hole 114, the second through hole 121, the third through hole 134, and the fourth through hole 144 are connected to one another. That is, in the stage 10J, the second groove 141 is provided in the fourth metal plate 140 connected to the shaft portion 200, and the heat insulating portion 150J is provided across the first metal plate 110 to the fourth metal plate 140.

In addition, when the first through hole 114, the second through hole 121, the third through hole 134, and the fourth through hole 144 are all provided in a circular shape, the inner region and the outer region of the stage 10J are separated from each other. Therefore, at least one of the first through hole 114, the second through hole 121, the third through hole 134, and the fourth through hole 144 is provided with the connection region 125 shown in FIG. 7.

In the inner region of the stage 10J, the circulating flow paths 112 and 122 overlap each other. In the outer region of the stage 10J, the heaters 113 and 123 overlap each other. In the stage 10J, the heaters 113 and 123 can be controlled independently, and the conditions of the cooling medium flowing through the circulating flow paths 112 and 122 can also be controlled independently. Since the heater 113 heats the outer region of the first metal plate 110, and the cooling medium flowing through the circulating flow path 112 cools the inner region of the first metal plate 110 in the stage 10J, the temperature difference between the inner region and the outer region is increased. Further, the temperature difference between the inner region and the outer region can be adjusted by controlling the heater 123 of the second metal plate 120 and the cooling medium flowing through the circulating flow path 122. Since the heat insulating portion 150J is provided across the first metal plate 110 to the fourth metal plate 140 in the stage 10J, the heat conduction from the inner region to the outer region and the heat conduction from the outer region to the inner region can be further suppressed.

### <Modification 11>

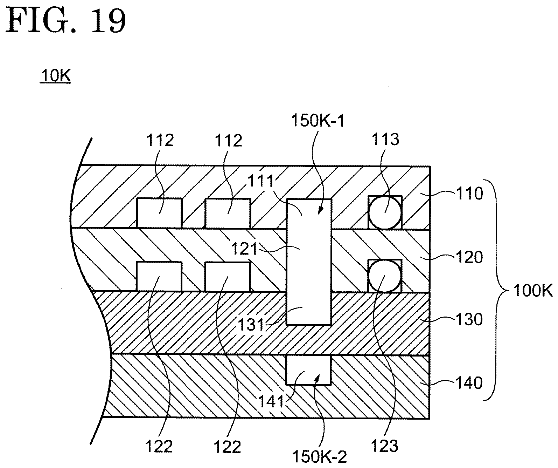

Another modification of the stage 10 according to an embodiment of the present invention is described with reference to FIG. 19. In addition, a description of a configuration that is the same as or similar to the configuration of the stage 10 to 10J may be omitted in the following description.

FIG. 19 is a schematic cross-sectional view showing a configuration of a plate portion 100K of a stage 10K according to an embodiment of the present invention.

As shown in FIG. 19, the plate portion 100K of the stage 10K includes the first metal plate 110, the second metal plate 120, the third metal plate 130, and the fourth metal plate 140. The first metal plate 110 is provided with the first groove 111, the circulating flow path 112, and the heater 113. The second metal plate 120 is provided with the through hole 121, the circulating flow path 122, and the heater 123. The third metal plate 130 is provided with the second groove 131. The fourth metal plate 140 is provided with the third groove 141. In the plate portion 100J, a first heat insulating portion 150J-1 is formed in which the first groove 111, the through hole 121, and the second groove 131 are connected to one another. Further, a second heat insulating portion 150J-2 is formed in which the third groove 141 is closed by the third metal plate 130. That is, the stage 10K is provided with a heat insulating portion 150K that is divided into two.

In the inner region of the stage 10K, the circulating flow paths 112 and 122 overlap each other. In the outer region of the stage 10K, the heaters 113 and 123 overlap each other. In the stage 10K, the heaters 113 and 123 can be controlled independently, and the conditions of the cooling medium flowing through the circulating flow paths 112 and 122 can also be controlled independently. Since the heater 113 heats the outer region of the first metal plate 110, and the cooling medium flowing through the circulating flow path 112 cools the inner region of the first metal plate 110 in the stage 10K, the temperature difference between the inner region and the outer region is increased. Further, the temperature difference between the inner region and the outer region can be adjusted by controlling the heater 123 of the second metal plate 120 and the cooling medium flowing through the circulating flow path 122. Since the heat insulating portion 150K is provided across the first metal plate 110 to the fourth metal plate 140 in the stage 10K, heat conduction from the inner region to the outer region and heat conduction from the outer region to the inner region can be further suppressed.

Although FIG. 19 shows the heat insulating portion 150K divided into two, the number of divisions of the heat insulating portion 150K may be three or more.

### <Modification 12>

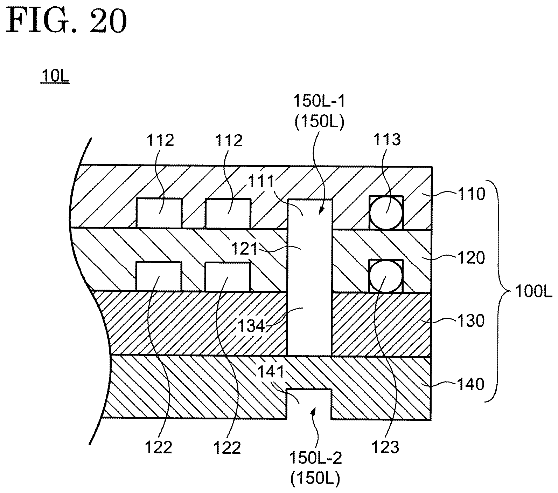

Another modification of the stage 10 according to an embodiment of the present invention is described with reference to FIG. 20. In addition, a description of a configuration that is the same as or similar to the configuration of the stage 10 to 10K may be omitted in the following description.

FIG. 20 is a schematic cross-sectional view showing a configuration of a plate portion 100L of a stage 10L according to an embodiment of the present invention.

As shown in FIG. 20, the plate portion 100L of the stage 10L includes the first metal plate 110, the second metal plate 120, the third metal plate 130, and the fourth metal plate 140. The first metal plate 110 is provided with the first groove 111, the circulating flow path 112, and the heater 113. The second metal plate 120 is provided with the first through hole 121, the circulating flow path 122, and the heater 123. The third metal plate 130 is provided with the second through hole 134. The fourth metal plate 140 is provided with the second groove 141. One end of the opening surface of the second through hole 134 is closed by the fourth metal plate 140. In the plate portion 100J, a first heat insulating portion 150J-1 is formed in which the first groove 111, the first through hole 121, and the second through hole 134 are connected to one another. Further, although the second groove 141 is open to the outside of the stage 10L, the area in contact with the outside atmosphere is increased by providing the second groove 141. The second groove 141 also reduces the cross-sectional area of the heat conduction path connecting the inner region and the outer region. Therefore, the second groove 141 functions as a second heat insulating portion 150L-2 that suppresses heat conduction from the inner region to the outer region and from the outer region to the inner region. That is, the stage 10L is provided with a heat insulating portion 150L divided into two.

In the inner region of the stage 10L, the circulating flow paths 112 and 122 overlap each other. In the outer region of the stage 10L, the heaters 113 and 123 overlap each other. In the stage 10L, the heaters 113 and 123 can be controlled independently, and the conditions of the cooling medium flowing through the circulating flow paths 112 and 122 can also be controlled independently. Since the heater 113 heats the outer region of the first metal plate 110, and the cooling medium flowing through the circulating flow path 112 cools the inner region of the first metal plate 110 in the stage 10L, the temperature difference between the inner region and the outer region is increased. Further, the temperature difference between the inner region and the outer region can be adjusted by controlling the heater 123 of the second metal plate 120 and the cooling medium flowing through the circulating flow path 122. Since the heat insulating portion 150L is provided across the first metal plate 110 to the fourth metal plate 140 in the stage 10L, the heat conduction from the inner region to the outer region and the heat conduction from the outer region to the inner region can be further suppressed.

In addition, although FIG. 20 shows the second groove 141 in the fourth metal plate 140 in contact with the outside atmosphere, the stage 10L may also be configured so that a groove in the first metal plate 110 that is in contact with the outside atmosphere is provided.

### <Modification 13>

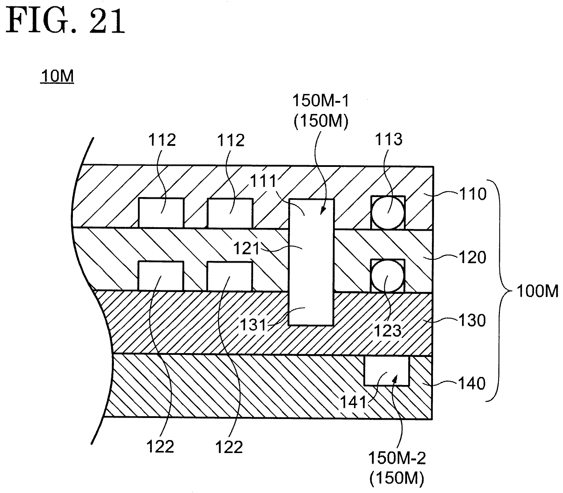

Another modification of the stage 10 according to an embodiment of the present invention is described with reference to FIG. 21. In addition, a description of a configuration that is the same as or similar to the configuration of the stage 10 to 10L may be omitted in the following description.

FIG. 21 is a schematic cross-sectional view showing a configuration of a plate portion 100M of a stage 10M according to an embodiment of the present invention.

As shown in FIG. 21, the plate portion 100M of the stage 10M includes the first metal plate 110, the second metal plate 120, the third metal plate 130, and the fourth metal plate 140. The first metal plate 110 is provided with the first groove 111, the circulating flow path 112, and the heater 113. The second metal plate 120 is provided with the through hole 121, the circulating flow path 122, and the heater 123. The third metal plate 130 is provided with the second groove 131. The fourth metal plate 140 is provided with the third groove 141. In the plate portion 100M, a first heat insulating portion 150M -1 is formed in which the first groove 111, the through hole 121, and the second groove 131 are connected to one another. Further, a second heat insulating portion 150M-2 is formed in which the opening surface of the third groove 141 is closed by the third metal plate 130. That is, the stage 10M is provided with a heat insulating portion 150M divided into two. However, in a plan view, the second heat insulating portion 150M-2 does not overlap the first heat insulating portion 150M-1. In a plan view, the second heat insulating portion 150M-2 overlaps the heaters 113 and 123. Further, for convenience, the following description is given assuming that the first heat insulating portion 150M-1 is the boundary between the inner region and the outer region, and the second heat insulating portion 150M-2 is provided in the outer region.

In the inner region of the stage 10M, the circulating flow paths 112 and 122 overlap each other. In the outer region of the stage 10M, the heaters 113 and 123 overlap each other. In the stage 10M, the heaters 113 and 123 can be controlled independently, and the conditions of the cooling medium flowing through the circulating flow paths 112 and 122 can also be controlled independently. Since the heater 113 heats the outer region of the first metal plate 110, and the cooling medium flowing through the circulating flow path 112 cools the inner region of the first metal plate 110 in the stage 10M, the temperature difference between the inner region and the outer region is increased. Further, the temperature difference between the inner region and the outer region can be adjusted by controlling the heater 123 of the second metal plate 120 and the cooling medium flowing through the circulating flow path 122. In the stage 10M, the first heat insulating portion 150M-1 can suppress heat conduction from the inner region to the outer region and heat conduction from the outer region to the inner region. Furthermore, in a position closer to the heaters 113 and 123 in the outer region, the second heat insulating portion 150M-2 can suppress the conduction of heat from the heaters 113 and 123.

In addition, although FIG. 21 shows the second heat insulating portion 150M-2 formed by the third groove 141 provided in the fourth metal plate 140, the second heat insulating portion 150M-2 may be formed by a groove (a groove different from the second groove 131) provided in the third metal plate 130, or may be formed by a groove provided in the third metal plate 130 and the third groove 141 provided in the fourth metal plate 140. Further, the width of the second groove 141 may be increased so that the second heat insulating portion 150M-2 overlaps the first heat insulating portion 150M-1 in the plan view. Furthermore, the second heat insulating portion 150M-2 may be provided in the inner region.

In the present embodiment, a configuration in which the configurations described in Modifications 1 to 13 are appropriately combined can also be applied.

As described above, the stage 10 according to an embodiment of the present invention including the configurations described in the Modifications 1 to 13 includes the heat insulating portion 150 in which the first groove 111 of the first metal plate 110, the through hole 121 of the second metal plate 120, and the second groove of the third metal plate 130 are connected to one another. Further, a first circulating flow path for cooling the inner region of the first metal plate 110 and a first heater for heating the outer region of the first metal plate 110 are provided with the heat insulating portion 150 sandwiched therebetween. With this configuration, the temperature difference between the inner region and the outer region can be increased in the stage 10. Furthermore, the stage 10 includes a second circulating flow path overlapping the first circulating flow path or a second heater overlapping the first heater. The conditions of the cooling medium flowing through the first circulating flow path and the conditions of the cooling medium flowing through the second circulating flow path can be controlled independently. The first heater and the second heater can be controlled independently. Therefore, the temperature of the inner region can be adjusted by controlling the conditions of the cooling medium flowing through the second circulating flow path, or the temperature of the outer region can be adjusted by controlling the second heater. Accordingly, in the stage 10, not only the temperature difference between the inner region and the outer region can be increased, but also the temperature difference can be adjusted.

<Second Embodiment>

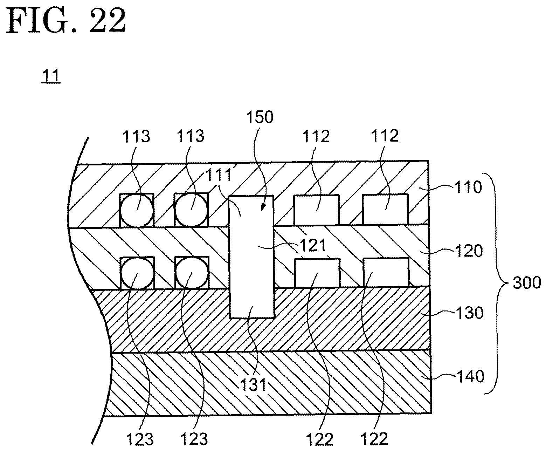

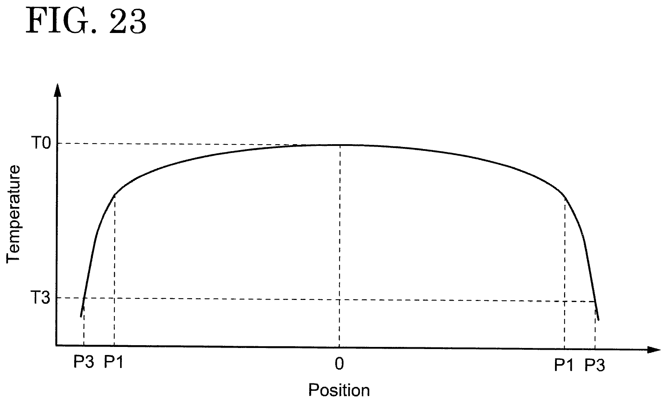

A stage 11 according to an embodiment of the present invention is described with reference to FIGS 22 and 23. In addition, a description of a configuration that is the same as or similar to the configuration of the stage 10 may be omitted in the following description.

FIG. 22 is a schematic cross-sectional view showing a configuration of the stage 11 according to an embodiment of the present invention.

As shown in FIG. 22, a plate portion 300 of the stage 11 includes the first metal plate 110, the second metal plate 120, the third metal plate 130, and the fourth metal plate 140. The first metal plate 110 includes the first groove 111, the circulating flow path 112, and the heater 113. The second metal plate 120 includes the through hole 121, the circulating flow path 122, and the heater 123. The third metal plate 130 includes the second groove 131. The plate portion 100 of the stage 11 includes the heat insulating portion 150 in which the first groove 111 of the first metal plate 110, the through hole 121 of the second metal plate 120, and the second groove 131 of the third metal plate 130 are connected to one another. The circulating flow paths 112 and 122 and the heaters 113 and 123 are provided in the outer region and the inner region, respectively, with the heat insulating portion 150 as a boundary. That is, in the inner region, the heaters 113 and 123 overlap each other. Further, in the outer region, the circulating flow paths 112 and 122 overlap each other.

The heat insulating portion 150 can suppress heat conduction from the inner region to the outer region and from the outer region to the inner region in each of the first metal plate 110 to the third metal plate 110. As a result, the temperature difference between the inner region and the outer region can be increased in the stage 11.

FIG. 23 is a graph illustrating a temperature gradient profile of 11 according to an embodiment of the present invention.

In FIG. 23, the horizontal axis indicates the position of the surface of the first metal plate 110 along a predetermined direction with the center position of the surface of the first metal plate 110 being zero, and the vertical axis indicates the surface temperature of the surface of the first metal plate 110. The first position P1 and the third position P3 represent the positions of the heat insulating portion 150 and the circulating flow path 112, respectively. That is, the region between the two P1s corresponds to the inner region, and the region between the P1 and the P3 corresponds to the outer region.

In the stage 11, the inner region of the first metal plate 110 is heated by controlling the heaters 113 and 123 in the inner regions of the first metal plate 110 and the second metal plate 120. On the other hand, the outer region of the first metal plate 110 is cooled by controlling the conditions of the cooling medium flowing through the circulation paths 112 and 122 in the outer regions of the first metal plate 110 and the second metal plate 120. The heat of the inner region of the first metal plate 110 is conducted to the outer region. However, since the heat insulating portion 150 is provided between the inner region and the outer region, the heat conduction path between the inner region and the outer region is restricted, and the heat conduction from the outer region to the inner region is suppressed. Therefore, even when the inner region is heated by the heaters 113 and 123, the temperature rise in the outer region is suppressed. Further, the temperature difference between the inner region and the outer region increases due to the reduction in the heat flow rate caused by the heat insulating portion 150. For example, the maximum temperature difference between the highest surface temperature T0 measured near the center of the first metal plate 110 and the lowest surface temperature T3 measured near the circulating flow path 112 is higher than or equal to 20°C, preferably greater than or equal to 60°C, and more preferably greater than or equal to 100°C. As described above, in the stage 11, the heaters 113 and 123 can be controlled independently, and the conditions of the cooling medium can also be controlled independently. Therefore, in the stage 11, the temperature difference between the inner region and the outer region can be increased while adjusting the temperatures of the inner region and the outer region.

As described above, the heat insulating portion 150 can suppress the heat from the heaters 113 and 123 provided in the outer region from being conducted to the inner region in the stage 11. That is, since the cross-sectional area of the heat conduction path connecting the outer region and the inner region of the plate portion 100 is reduced by the space formed by the heat insulating portion 150, the heat insulating portion 150 can function as a thermal blockage / thermal choke. As a result, since the temperature difference between the inner region and the outer region becomes large in the stage 11, the temperature of the inner region of the wafer can be corrected and the temperature distribution in the wafer can be made uniform, for example, when the stage 11 is applied to a wafer in which the temperature drop in the inner region is significant.

### <Third Embodiment>

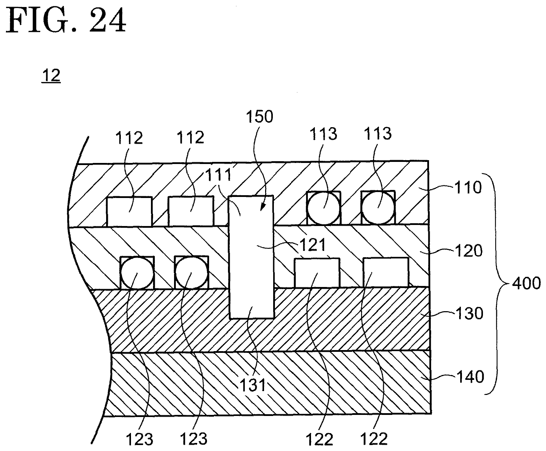

A stage 12 according to an embodiment of the present invention is described with reference to FIG. 24. In addition, a description of a configuration that is the same as or similar to the configuration of the stage 10 or the stage 11 may be omitted in the following description.

FIG. 24 is a schematic cross-sectional view showing a configuration of the stage 12 according to an embodiment of the present invention.

As shown in FIG. 24, a plate portion 400 of the stage 12 includes the first metal plate 110, the second metal plate 120, the third metal plate 130, and the fourth metal plate 140. The first metal plate 110 includes the first groove 111, the circulating flow path 112, and the heater 113. The second metal plate 120 includes the through hole 121, the circulating flow path 122, and the heater 123. The third metal plate 130 includes the second groove 131. The plate portion 400 of the stage 12 also includes the heat insulating portion 150 in which the first groove 111 of the first metal plate 110, the through hole 121 of the second metal plate 120, and the second groove 131 of the third metal plate 130 are connected to one another. In the first metal plate 110, the circulating flow path 112 and the heater 113 are provided in an inner region and an outer region, respectively, with the heat insulating portion 150 as a boundary. In the second metal plate 120, the circulating flow path 122 and the heater 123 are provided in an outer region and an inner region, respectively, with the heat insulating portion 150 as the boundary. That is, in the inner region, the circulating flow path 112 and the heater 123 overlap each other. In the outer region, the heater 113 and the circulating flow path 122 overlap each other.

In the stage 12, the temperature of the first metal plate 110 is controlled by using a cooling medium flowing through the circulating flow path 112 and the heater 113 each provided in the first metal plate 110. At this time, since the heat insulating portion 150 can suppress heat conduction from the outer region to the inner region, the temperature gradient profile shown in FIG. 8 is obtained and the temperature difference between the inner region and the outer region can be increased. Further, the cooling medium flowing through the circulating flow path 122 can also be used to suppress heat conduction from the first metal plate 110 to the second metal plate 120.

Further, in the stage 12, the temperature of the first metal plate 110 is controlled using the heater 123 and a cooling medium flowing through the circulating flow path 112 each provided in the second metal plate 120. At this time, since the heat insulating portion 150 can suppress heat conduction from the inner region to the outer region, the temperature gradient profile shown in FIG. 23 can be obtained and the temperature difference between the inner region and the outer region can be increased.

Therefore, two types of temperature gradient profiles with large temperature differences between the inner region and the outer region can be realized in the stage 12.

### <Modification 1>

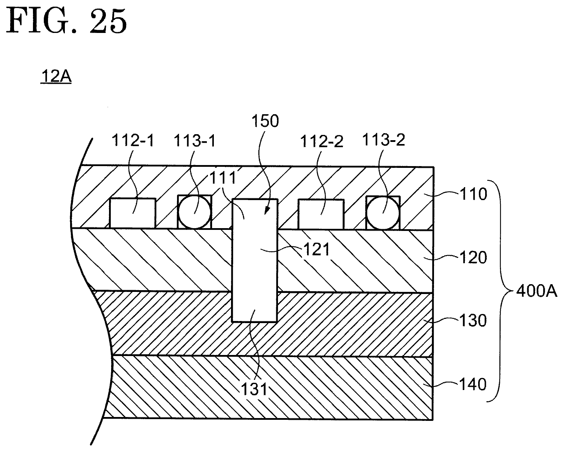

A modification of the stage 12 according to an embodiment of the present invention is described with reference to FIG. 25. In addition, a description of a configuration that is the same or similar to the configuration of the stage 12 may be omitted in the following description.

FIG. 25 is a schematic cross-sectional view showing a configuration of a plate portion 400A of a stage 12A according to an embodiment of the present invention.

As shown in FIG. 25, the plate portion 400A of the stage 12A includes the first metal plate 110, the second metal plate 120, the third metal plate 130, and the fourth metal plate 140. The first metal plate 110 is provided with the first groove 111, a first circulating flow path 112-1, a second circulating flow path 112-2, a first heater 113-1, and a second heater 113-2. The second metal plate 120 is provided with the through hole 121. The third metal plate 130 is provided with the second groove 131. The plate portion 400A of the stage 12A also includes the heat insulating portion 150 in which the first groove 111 of the first metal plate 110, the through hole 121 of the second metal plate 120, and the second groove 131 of the third metal plate 130 are connected to one another. The first circulating flow path 112-1 and the first heater 113-1 are provided in an inner region with the heat insulating portion 150 as a boundary. The second circulating flow path 112-2 and the second heater 113-2 are provided in an outer region with the heat insulating portion 150 as the boundary.

In the stage 12A, the temperature of the first metal plate 110 is controlled using a cooling medium flowing through the first circulating flow path 112-1 provided in the inner region and the second heater 113-2 provided in the outer region. At this time, since the heat insulating portion 150 can suppress heat conduction from the outer region to the inner region, the temperature gradient profile shown in FIG. 8 can be obtained and the temperature difference between the inner region and the outer region can be increased.

Further, in the stage 12A, the first heater 113-1 provided in the inner region and a cooling medium flowing through the circulating flow path provided in the outer region are used to control the temperature of the first metal plate 110. At this time, since the heat insulating portion 150 can suppress the heat conduction to the inner region, the temperature gradient profile shown in FIG. 23 can be obtained and the temperature difference between the inner region and the outer region can be increased.

Therefore, two types of temperature gradient profiles with large temperature differences between the inner and outer regions can be realized in the stage 12A. In addition, a circulating flow path and a heater may be arranged in the second metal plate 120 or the third metal plate 130, similar to the first metal plate 110. In this case, the temperature of the first metal plate 110 can be adjusted using a cooling medium flowing through the circulating flow path and the heater, each arranged in the second metal plate 120 or the third metal plate 130.

### <Fourth Embodiment>

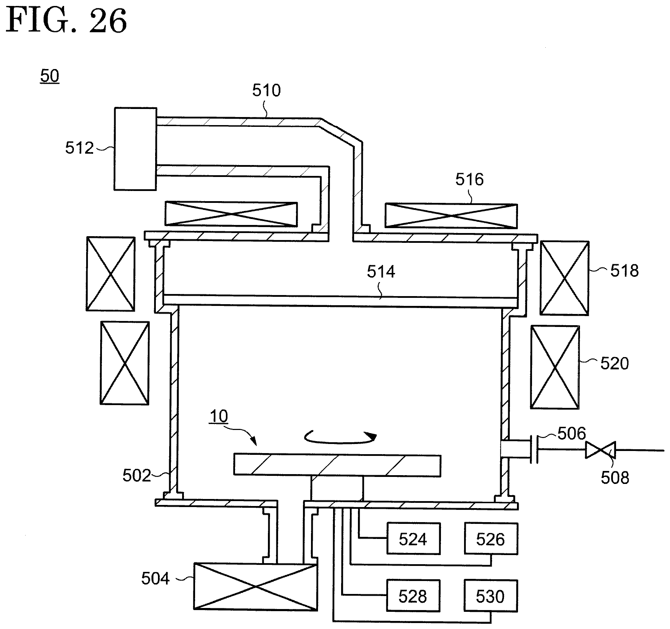

An etching apparatus 50 according to an embodiment of the present invention is described with reference to FIG. 26. The etching apparatus 50 includes the stage 10. Therefore, a description of the same or similar configuration as that of the stage 10 described in the First Embodiment may be omitted in the following description.

FIG. 26 is a schematic cross-sectional view showing a configuration of the etching apparatus 50 according to an embodiment of the present invention.

The etching apparatus 50 can perform dry etching on various films. The etching apparatus 50 includes a chamber 502. The chamber 502 supplies a space to perform etching on a film of a conductor, an insulator, or a semiconductor formed on a wafer.

An exhaust device 504 is connected to the chamber 502, by which the inside of the chamber 502 can be set under a reduced-pressure atmosphere. The chamber 502 is further provided with an inlet tube 506 for introducing a reaction gas which is supplied to the chamber 502 through a valve 508. For example, a fluorine-containing organic compound such as tetrafluorocarbon (CF₄), octafluorocyclobutane (c-C₄F₈), decafluorocyclopentane (*c*-C₅F₁₀), hexafluorobutadiene (C₄F₆) is used as the reaction gas.

A microwave source 512 may be provided at an upper portion of the chamber 502 through a waveguide tube 510. The microwave source 512 has an antenna and the like for supplying a microwave and outputs a high-frequency microwave such as a microwave of 2.45 GHz and a radio wave (RF) of 13.56 MHz. The microwave generated by the microwave source 512 is transmitted to the upper portion of the chamber 502 with the waveguide tube 510 and then introduced into the chamber 502 through a window 514 including quartz, ceramic, or the like. The reaction gas is plasmatized with the microwave, and the etching proceeds with electrons, ions, and radicals included in the plasma.

The stage 10 for placing a wafer is provided at a lower portion of the chamber 502. A power source 524 is connected to the stage 10, and high-frequency electric power is supplied to the stage 10, thereby forming an electric field in a direction perpendicular to the surfaces of the stage 10 and the wafer with the microwave. Magnets 516, 518, and 520 may be provided at the upper portion and on a side surface of the chamber 502. The magnets 516, 518, and 520 may each be a permanent magnet or an electromagnet having an electromagnetic coil. A magnetic component parallel to the surfaces of the stage 10 and the wafer is generated with the magnets 516, 518, and 520. The electrons in the plasma resonate upon receiving a Lorentz force in association with the electrical field generated by the microwave and are bound on the surfaces of the stage 10 and the wafer. Accordingly, a high-density plasma can be generated on the surface of the wafer.

A heater power source 530 for controlling the heater 113 provided to the stage 10 is connected to the stage 10. As an optional structure, a power source 526 for an electrostatic chuck for fixing the wafer to the stage 10, a temperature controller 528 for controlling the temperature of a medium circulated in the stage 10, and a rotation-controlling device (not shown in the figures) for rotating the stage 10 may be further connected to the stage 10.

### <Fifth Embodiment>

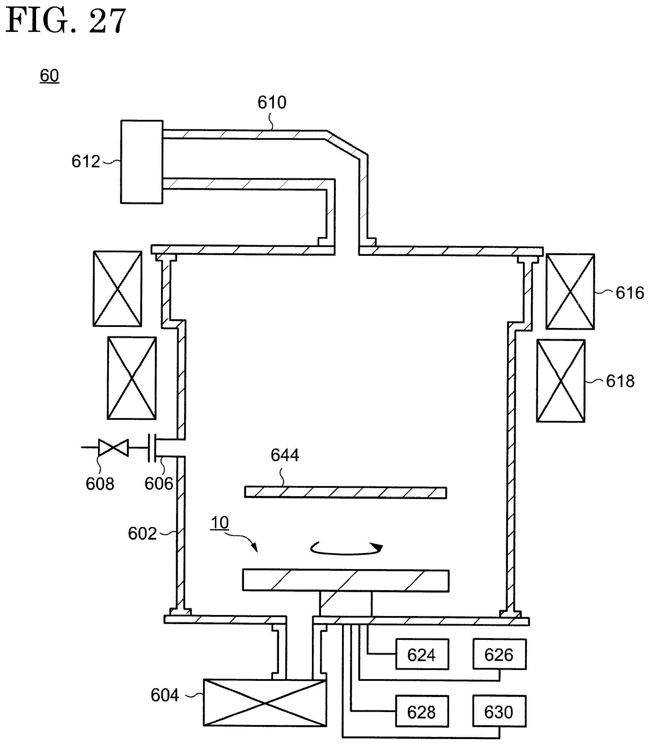

A CVD apparatus 60 according to an embodiment of the present invention is described with reference to FIG. 27. The CVD apparatus 60 includes the stage 10. Therefore, a description of the same or similar configuration as that of the stage 10 described in the First Embodiment may be omitted in the following description.

FIG. 27 is a schematic cross-sectional view showing a configuration of the CVD apparatus 60 according to an embodiment of the present invention.

The CVD apparatus 60 includes a chamber 602. The CVD apparatus 60 provides a space for chemically reacting a reaction gas to form various films on a wafer.

An exhaust apparatus 604 is connected to the chamber 602, by which the pressure in the chamber 602 can be reduced. The chamber 602 is further provided with an inlet tube 606 for introducing the reaction gas, and the reaction gas for film formation is introduced into the chamber 602 through a valve 608. As the reaction gas, a variety of gases can be used depending on the films to be formed. The gas may be a liquid at a normal temperature. For example, thin films of silicon, silicon oxide, silicon nitride, and the like can be prepared using silane, dichlorosilane, tetraethoxysilane, and the like. Further, metal films of tungsten, aluminum, and the like can be prepared using tungsten fluoride, trimethylaluminum, and the like.

Similar to the etching apparatus 50, a microwave source 612 may be provided at an upper portion of the chamber 602 through a waveguide tube 610. A microwave generated with the microwave source 612 is introduced into the chamber 602 with the waveguide tube 610. The reaction gas is plasmatized with the microwave, and the chemical reaction of the gas is promoted by a variety of active species included in the plasma. Products obtained by the chemical reactions are deposited over a wafer, resulting in a thin film. As an optional element, a magnet 644 may be provided in the chamber 602 in order to increase plasma density. The stage 10 is disposed at a lower portion of the chamber 302, which enables deposition of a thin film in a state where a wafer is placed over the stage 10. Similar to the etching apparatus 50, magnets 616 and 618 may be further provided on a side surface of the chamber 602.

A heater power source 630 for controlling the heater 113 provided in the stage 10 is further connected to the stage 10. As an optional element, a power source 624 for supplying a high-frequency electric power to the stage 10, a power source 626 for an electrostatic chuck, a temperature controller 628 for temperature control of a cooling medium circulated in the stage 10, or a rotation-controlling device (not shown in the figures) for rotating the stage 10, and the like may be connected to the stage 10.

### <Sixth Embodiment>

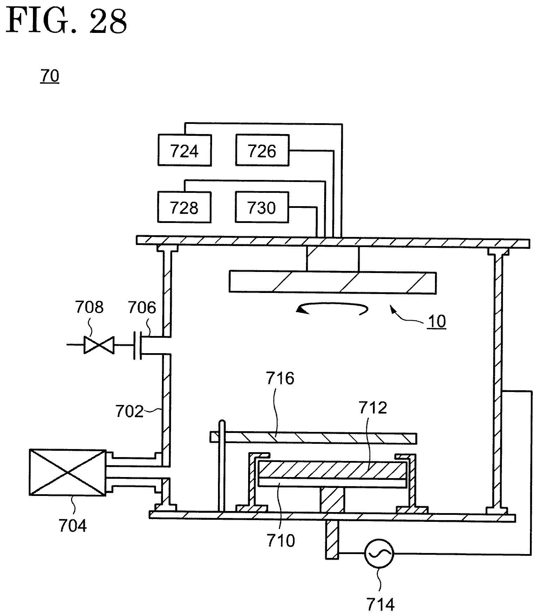

A sputtering apparatus 70 according to an embodiment of the present invention is described with reference to FIG. 28. The sputtering apparatus 70 includes the stage 10. Therefore, a description of the same or similar configuration as that of the stage 10 described in the Second Embodiment may be omitted in the following description.

FIG. 28 is a schematic cross-sectional view showing a configuration of the sputtering apparatus 70 according to an embodiment of the present invention.

The sputtering apparatus 70 includes a chamber 702. The sputtering apparatus 70 provides a space for collision of high-speed ions with a target and deposition of target atoms generated by the collision on a wafer.

An exhaust apparatus 704 for reducing pressure in the chamber 702 is connected to the chamber 702. An inlet tube 706 for supplying a sputtering gas such as argon into the chamber 702 and a valve 708 are provided to the chamber 702.

A target stage 710 for supporting a target containing a material to be deposited and functioning as a cathode is arranged at a lower portion of the chamber 702, over which the target 712 is provided. A high-frequency power source 714 is connected to the target stage 710, and plasma can be generated in the chamber 702 with the high-frequency power source 714.

The stage 10 may be disposed at an upper portion of the chamber 702. In this case, film-formation proceeds in the state where the wafer is placed under the stage 10. Similar to the etching apparatus 50 and the CVD apparatus 60, a heater-power source 730 is connected to the stage 10. A power source 724 for supplying a high-frequency electric power to the stage 10, a power source 726 for an electrostatic chuck, a temperature controller 728, and a rotation-controlling device (not shown in the figures) for rotating the stage 10 may be connected to the stage 10.

Argon ions accelerated with the plasma generated in the chamber 702 collide with the target 712, and the atoms of the target 712 are sputtered. The sputtered atoms fly to the wafer placed under the stage 10 while a shutter 716 is opened and are deposited.

In FIG. 28, the configuration is exemplified in which the stage 10 and the target stage 710 are respectively disposed at the upper portion and the lower portion of the chamber 702. However, the sputtering apparatus 70 is not limited to this configuration, and the sputtering apparatus 70 may be configured so that the target 712 is positioned over the stage 10. Alternatively, the stage 10 may be disposed so that a main surface of the wafer is arranged perpendicular to the horizontal plane, and the target stage 710 may be provided so as to face the stage 10.

### <Seventh Embodiment>

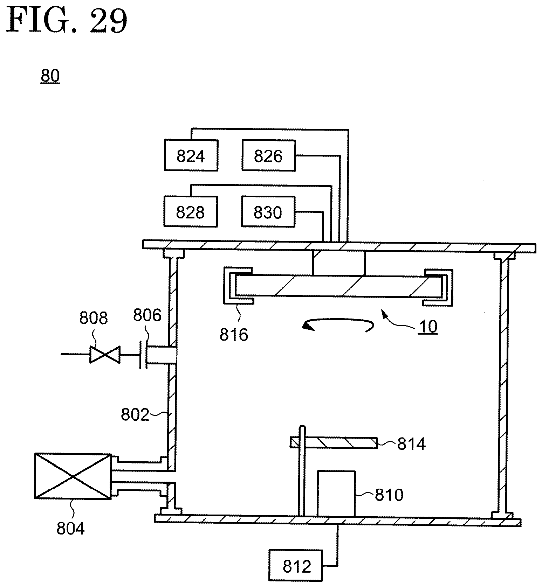

An evaporation apparatus 80 according to an embodiment of the present invention is described with reference to FIG. 29. The evaporation apparatus 80 includes the stage 10. Therefore, a description of the same or similar configuration as that of the stage 10 described in the First Embodiment may be omitted in the following description.

FIG. 29 is a schematic cross-sectional view showing a configuration of the evaporation apparatus 80 according to an embodiment of the present invention.

The evaporation apparatus 80 includes a chamber 802. The chamber 802 provides a space for evaporating a material in an evaporation source 810 and depositing the evaporated material over a wafer.

An exhaust apparatus 804 for making the inside of the chamber 802 a high vacuum is connected to the chamber 802. An inlet tube 806 for returning the inside of the chamber 802 to an atmospheric pressure is provided to the chamber 802, and an inert gas such as nitrogen and argon is introduced into the chamber 802 through a valve 808.

The stage 10 may be disposed at an upper portion of the chamber 802. Deposition of the material proceeds in a state where the wafer is placed under the stage 10. Similar to the etching apparatus 50, the CVD apparatus 60, and the sputtering apparatus 70, a heater-power source 828 is connected to the stage 10. As an optional structure, a power source 824 for an electrostatic chuck, a temperature controller 826, and a rotation-controlling device 830 for rotating the stage 10 may be connected to the stage 10. The stage 10 may further include a mask holder 816 for fixing a metal mask between the wafer and the evaporation source 610. With this structure, it is possible to arrange the metal mask at a vicinity of the wafer so that an opening portion of the metal mask overlaps a region where the material is to be deposited.

The evaporation source is provided at a lower portion of the chamber 802 into which the material subjected to evaporation is charged. A heater for heating the material is provided to the evaporation source 810, and the heater is controlled with a controlling device 812. The inside of the chamber 802 is made a high vacuum using the exhaust apparatus 804, and the material is vaporized by heating the evaporation source 810 to start evaporation. A shutter 814 is opened when an evaporation rate becomes constant, by which deposition of the material is started over the wafer.

The stage 10 is used in the etching apparatus 50, the CVD apparatus 60, the sputtering apparatus 70, and the evaporation apparatus 80 described in the Fourth to Seventh Embodiments. When the stage 10 is used, the temperature distribution in the wafer in which the temperature drop in the outer region is significant can be made uniform.

Each of the embodiments described above as the embodiments of the present invention can be appropriately combined and implemented as long as no contradiction is caused. Further, the addition, deletion, or design change of components, or the addition, deletion, or condition change of processes as appropriate by those skilled in the art based on each of embodiments are also included in the scope of the present invention as long as they are provided with the gist of the present invention.

Further, it is understood that, even if the effect is different from those provided by each of the above-described embodiments, the effect obvious from the description in the specification or easily predicted by persons ordinarily skilled in the art is apparently derived from the present invention.

### REFERENCES SIGN LIST

10, 10A, 10B, 10C, 10D, 10E, 10F, 10G, 10H, 10I, 10J, 10K, 10L, 10M, 11, 12, 12A: stage, 50: etching apparatus, 60: CVD apparatus, 70: sputtering apparatus, 80: evaporation apparatus, 100, 100A, 100B, 100C, 100D, 100E, 100F, 100G, 100H, 1001, 100J, 100K, 100L, 100M: plate portion, 101: first surface, 102: second surface, 110: first metal plate, 111: groove, 112: circulating flow path, 112a: inlet, 112b: outlet, 113: heater, 120: second metal plate, 121: through hole, 122: circulating flow path, 123: heater, 125, 125a, 125b: connection region, 130: third metal plate, 131: groove, 132: circulating flow path, 133: heater, 134: through hole, 140: fourth metal plate, 141: groove, 144: through hole, 150, 150L, 150M: heat insulating portion, 200: shaft portion, 300: plate portion, 400, 400A: plate portion, 502: chamber , 504: exhaust device, 506: inlet tube, 508: valve, 510: waveguide tube, 512: microwave source, 514: window, 516, 518, 520: magnet, 524, 526: power source, 528: temperature controller, 530: heater power source, 602: chamber, 604: exhaust device, 606: inlet tube, 608: valve, 610: waveguide, 612: microwave source, 616, 618: magnet, 624, 626: power source, 628: temperature controller, 630: heater power source, 644: magnet, 702: chamber , 704: exhaust device, 706: inlet tube, 708: valve, 710: target stage, 712: target, 714: high frequency power source, 716: shutter, 724, 726: power source, 728: temperature controller, 730: heater power source, 802: chamber, 804: exhaust device, 806: inlet tube, 808: valve, 810: evaporation source, 812: controlling device, 814: shutter, 816: mask holder, 824: power source, 826: temperature controller, 828: heater power source, 830: rotation-controlling device

## Claims

1. A stage, comprising:
a first metal plate comprising a first groove;
a second metal plate comprising a first through hole, below the first metal plate;
a third metal plate comprising at least one of a second groove and a second through hole, below the second metal plate;
a heat insulating portion in which the first groove, the first through hole, and the at least one of the second groove and the second through hole are connected to one another;
a first circulating flow path and a first heater provided in one metal plate of the first metal plate, the second metal plate, and the third metal plate; and
one of a second circulating flow path and a second heater,
wherein the first circulating flow path and the second circulating flow path are provided in a first region defined by the heat insulating portion as a boundary, and
wherein the first heater and the second heater are provided in a second region opposite the first region defined by the heat insulating portion as the boundary.

2. The stage according to claim 1, further comprising a fourth metal plate below the third metal plate,
wherein the second circulating flow path and the second heater are provided in the fourth metal plate.

3. The stage according to claim 1, wherein the first region is a region surrounded by the heat insulating portion.

4. The stage according to claim 1, wherein the second region is a region surrounded by the heat insulating portion.

5. The stage according to claim 1, wherein the second heater is provided in the one metal plate in which the first heater is provided.

6. The stage according to claim 5,
wherein one of two adjacent metal plates is the one metal plate in which the first heater is provided, and
wherein the second circulating flow path is provided in another of the two adjacent metal plates.

7. The stage according to claim 5,
wherein one of two spaced apart metal plates is the one metal plate in which the first heater is provided, and
wherein the second circulating flow path is provided in another of the two spaced apart metal plates.

8. The stage according to claim 1,
wherein one of two adjacent metal plates is the one metal plate in which the first heater is provided, and
wherein the second heater is provided in another of the two adjacent metal plates.

9. The stage according to claim 8, wherein the second circulating flow path is provided in the other of the two adjacent metal plates.

10. The stage according to claim 8, wherein the second circulating flow path is provided in a metal plate different from the two adjacent metal plates.

11. The stage according to claim 1,
wherein one of two spaced apart metal plates is the one metal plate in which the first heater is provided, and
wherein the second heater is provided in another of the two spaced apart metal plates.

12. The stage according to claim 11, wherein the second circulating flow path is provided in the other of the two spaced apart metal plates.

13. The stage according to claim 11, wherein the second circulating flow path is provided in a metal plate different from the two spaced apart metal plates.

14. The stage according to claim 1, wherein a cross-sectional diameter of the second heater is different from a cross-sectional diameter of the first heater.

15. The stage according to claim 1, wherein the first heater and the second heater are electrically isolated from each other.

16. A stage, comprising:
a first metal plate comprising a first groove;
a second metal plate comprising a first through hole, below the first metal plate;
a third metal plate comprising at least one of a second groove and a second through hole, below the second metal plate;
a heat insulating portion in which the first groove, the first through hole, and at least one of the second groove and the second through hole are connected to one another;
a first circulating flow path provide in one metal plate of the first metal plate, the second metal plate, and the third metal plate;
a heater provide in the other metal plate different from the one metal plate; and
at least one of a second circulating flow path and a second heater provided in a metal plate different from the one metal plate and the other metal plate,
wherein the first circulating flow path and the second circulating flow path are provided in a first region defined by the heat insulating portion as a boundary, and
wherein the first heater and the second heater are provided in a second region opposite the first region defined by the heat insulating portion as the boundary.

17. The stage according to claim 16, further comprising a fourth metal plate below the third metal plate,
wherein at least one of the second circulating flow path and the second heater is provided in the fourth metal plate.

18. The stage according to claim 16, wherein the first region is a region surrounded by the heat insulating portion.

19. The stage according to claim 16, wherein the second region is a region surrounded by the heat insulating portion.

20. The stage according to claim 16, the one metal plate and the other metal plate are adjacent to each other.

21. The stage according to claim 16, the one metal plate and the other metal plate are spaced apart each other.

22. A stage, comprising:
a first metal plate comprising a first groove;
a second metal plate comprising a first through hole, below the first metal plate;
a third metal plate comprising at least one of a second groove and a second through hole, below the second metal plate;
a heat insulating portion in which the first groove, the first through hole, and at least one of the second groove and the second through hole are connected to one another;
a first circulating flow path and a first heater provided in one metal plate of the first metal plate, the second metal plate, and the third metal plate; and
a second circulating flow path and a second heater,
wherein the first circulating flow path and the second heater is provided in a first region defined by the heat insulating portion as a boundary, and
wherein the first heater and the second circulating flow path are provided in a second region opposite the first region defined by the heat insulating portion as the boundary.

23. The stage according to claim 22, further comprising a fourth metal plate below the third metal plate,
wherein at least one of the second circulating flow path and the second heater is provided in the fourth metal plate.

24. The stage according to claim 22, wherein the second circulating flow path and the second heater are the one metal plate in which the first circulating flow path and the first heater.

25. The stage according to claim 22,
wherein one of two adjacent metal plates is the one metal plate in which the first circulating flow path and the first heater, and
wherein the second circulating flow path and the second heater are provided in the other of the two adjacent metal plates.

26. The stage according to claim 22,
wherein one of two spaced metal plates is the one metal plate in which the first circulating flow path and the second circulating flow path, and
wherein the second circulating flow path and the second heater are provided in the other of the two spaced metal plates.

27. The stage according to any one of claims 1 to 26, wherein a temperature difference between a minimum surface temperature and a maximum surface temperature of the first metal plate is higher than or equal to 20°C.
